# EUROPEAN PATENT APPLICATION

(11) **EP 4 672 303 A1**
(43) Date of publication of application: **31.12.2025**
(21) Application number: 24760115.6
(22) Date of filing: 06.02.2024
(51) Int. Cl.: H01L 21/304, C11D 7/24, C11D 7/26, C11D 7/32, C11D 7/34

(54) **METHOD FOR MANUFACTURING SEMICONDUCTOR SUBSTRATE, METHOD FOR MANUFACTURING PROCESSED SEMICONDUCTOR SUBSTRATE, AND COMPOSITION FOR PEELING AND DISSOLVING**

(30) Priority: 20.02.2023 JP 2023024286
(71) Applicant: Nissan Chemical Corporation, Tokyo 103-6119 (JP)
(72) Inventor: YAGYU, Masafumi, Toyama-shi, Toyama 939-2792 (JP); OKUNO, Takahisa, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2024/003850
(87) International publication number: WO 2024/176810

(57) **Abstract**

Provided is a method for producing a semiconductor substrate including a cleaning step of a semiconductor substrate, capable of removing (cleaning) an adhesive layer from a semiconductor substrate having the adhesive layer on a surface thereof more cleanly in a shorter time by a simple operation, a method for producing a processed semiconductor substrate including such a semiconductor production method, and a composition used in such a cleaning step.

A method for producing a semiconductor substrate, including a step of releasing and dissolving an adhesive layer on a semiconductor substrate using a releasing and dissolving composition, and cleaning the adhesive layer, in which the releasing and dissolving composition contains: a component [I]: a dissolution component containing a quaternary ammonium salt and an amide-based solvent, and a component [II]: a release component having a molecular weight of less than 160 and being composed of one or more solvents selected from an ether compound, a thioether compound, an aromatic hydrocarbon compound, an aliphatic hydrocarbon compound, an ester compound, and an amine compound, and a contact angle of the releasing and dissolving composition when the releasing and dissolving composition is added dropwise onto the adhesive layer disposed on the semiconductor substrate is more than 22.6 degrees and less than 46.1 degrees.

## Description

### Technical Field

The present invention relates to a method for producing a semiconductor substrate, a method for producing a processed semiconductor substrate, and a releasing and dissolving composition.

### Background Art

For a semiconductor wafer that has been conventionally integrated in a two-dimensional planar direction, a semiconductor integration technology is required by which a planar surface is further integrated (laminated) also in a three-dimensional direction for the purpose of further integration. This three-dimensional lamination is a technology of integrating multiple layer while connecting the layers by a through silicon via (TSV). At the time of multilayer integration, respective wafers to be integrated are thinned by polishing on the side opposite to the formed circuit surface (that is, the back surface), and the thinned semiconductor wafers are laminated.

A semiconductor wafer before thinning (also referred to herein simply as a wafer) is adhered to a support in order to be polished with a polishing apparatus. The adhesion at that time is referred to as temporary adhesion since the semiconductor wafer needs to be easily released after polishing. This temporary adhesion needs to allow easy removal from the support, the application of a large force for removal may cause the thinned semiconductor wafer to be cut or deformed, and the semiconductor wafer is easily removed such that such a situation does not occur. However, at the time of polishing the back surface of a semiconductor wafer, it is not preferable that the semiconductor wafer is detached or displaced due to polishing stress. Therefore, the performance required for temporary adhesion is to withstand the stress during polishing and to allow the semiconductor wafer to be easily removed after polishing. For example, there is a demand for performance having a high stress (strong adhesive force) in the planar direction at the time of polishing and a low stress (weak adhesive force) in a direction intersecting the planar direction, that is, in the longitudinal direction at the time of removal. In addition, the temperature may become a high temperature of 150°C or higher in the processing step, and further, heat resistance is also required.

Under such circumstances, in the semiconductor field, a polysiloxane-based adhesive that can have such performance is mainly used as a temporary adhesive. In polysiloxane-based adhesion using a polysiloxane-based adhesive, an adhesive residue often remains on a substrate surface after a thinned substrate is released, but in order to avoid defects in subsequent steps, a cleaning agent composition for removing the residue and cleaning a semiconductor substrate surface has been developed (see, for example, Patent Literature 1 and 2). Patent Literature 1 discloses a siloxane resin remover containing a polar aprotic solvent and a quaternary ammonium hydroxide, and Patent Literature 2 discloses a cured resin remover containing an alkyl ammonium fluoride.

In addition, Patent Literature 3 discloses a release composition containing a specific solvent, and describes that a semiconductor substrate is cleaned using the release composition.

However, in the recent semiconductor field, there is always a demand for a new cleaning agent composition, and there is always a demand for an effective cleaning agent composition and an effective production method.

### Citation List

### Patent Literature

Patent Literature 1: WO 2014/092022 A
Patent Literature 2: US 6,818,608
Patent Literature 3: WO 2021/193519 A

### Summary of Invention

### Technical Problem

The cleaning agent compositions described in Patent Literature 1 and 2 attempt to remove the adhesive residue from the substrate surface by dissolving the adhesive residue on the substrate surface, but it has been found that it takes a long time to remove the adhesive residue from the substrate surface by dissolution in this manner.

Meanwhile, as a result of examining a cleaning agent composition, the present inventors have found that when a composition containing a specific component is used, an adhesive layer can be released from a substrate by swelling the adhesive layer. The use of this composition containing a specific component is effective for removing the adhesive layer from the substrate in a short time. For example, the cleaning agent composition (release composition) described in Patent Literature 3 can also become an effective component for removing an adhesive layer from a substrate in a short time.

However, there is room for improvement from the viewpoint of removing an adhesive residue from a substrate surface more cleanly in a shorter time by a simple operation, and in search of a more effective production method, the development of a new production method and a composition used in the production method is underway.

The present invention has been made in view of the above circumstances, and an object of the present invention is to provide a method for producing a semiconductor substrate including a cleaning step of a semiconductor substrate, capable of removing (cleaning) an adhesive layer obtained using, for example, a siloxane-based adhesive from a semiconductor substrate having the adhesive layer on a surface thereof more cleanly in a shorter time by a simple operation, a method for producing a processed semiconductor substrate including such a semiconductor production method, and a composition used in such a cleaning step.

### Solution to Problem

As a result of intensive studies to solve the above problem, the present inventors have found that the above problem can be solved by cleaning an adhesive layer on a semiconductor substrate, in particular, an adhesive layer which is a cured film obtained from a siloxane-based adhesive containing a polyorganosiloxane component (A') that is cured by a hydrosilylation reaction using a composition containing a specific component, thereby simultaneously swelling, releasing, and dissolving the adhesive layer by one cleaning operation, and removing the adhesive layer from the semiconductor substrate, and completed the present invention.

That is, the present invention includes the following aspects.
[1] A method for producing a semiconductor substrate, including a step of releasing and dissolving an adhesive layer on a semiconductor substrate using a releasing and dissolving composition, and cleaning the adhesive layer,
   wherein the releasing and dissolving composition contains:
      a component [I]: a dissolution component containing a quaternary ammonium salt and an amide-based solvent, and
      a component [II]: a release component having a molecular weight of less than 160 and being composed of one or more solvents selected from an ether compound, a thioether compound, an aromatic hydrocarbon compound, an aliphatic hydrocarbon compound, an ester compound, and an amine compound, and
   a contact angle of the releasing and dissolving composition when the releasing and dissolving composition is added dropwise onto the adhesive layer disposed on the semiconductor substrate is more than 22.6 degrees and less than 46.1 degrees.
[2] The method for producing a semiconductor substrate according to [1], wherein the solvent of the ether compound or the thioether compound as the component [II] is a solvent represented by formula (L-1) below:

   [Chem. 1] **L¹-L³-L² (L-1)**

   in the formula, L¹ and L² each independently represent an alkyl group having 2 to 5 carbon atoms, and L³ represents O or S.
[3] The method for producing a semiconductor substrate according to [1], wherein the solvent of the aromatic hydrocarbon compound as the component [II] is a solvent represented by formula (L-2) below: 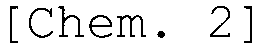 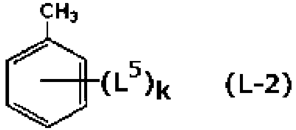 in the formula, L⁵' s represent a substituent substituted with a benzene ring and each independently represent an alkyl group having 1 to 4 carbon atoms, and k represents a number of L⁵ and is an integer of 0 to 5.
[4] The method for producing a semiconductor substrate according to [1], wherein the solvent of the aliphatic hydrocarbon compound as the component [II] is a solvent represented by formulae (L-3-0) to (L-3-5) below: 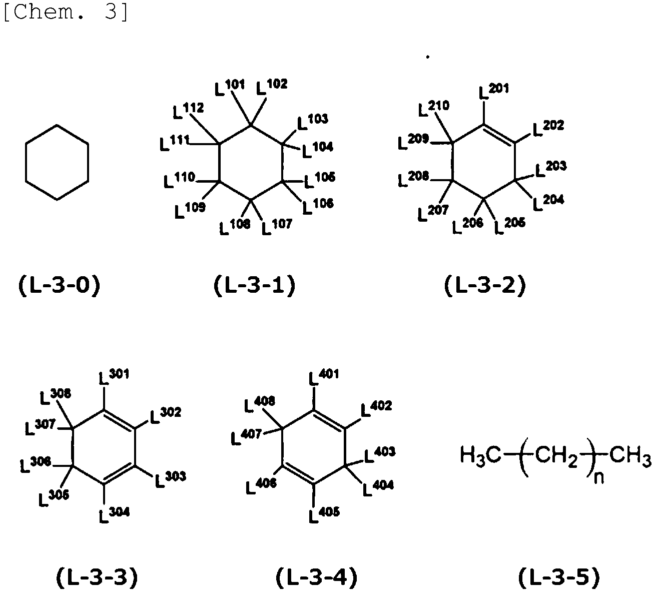 in the formulae, L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, but at least one of L¹⁰¹ to L¹¹² represents an alkyl group having 1 to 5 carbon atoms, an alkenyl group having 2 to 5 carbon atoms, or an alkynyl group having 2 to 5 carbon atoms; L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, but at least one of L²⁰¹ to L²¹⁰ represents an alkyl group having 1 to 5 carbon atoms, an alkenyl group having 2 to 5 carbon atoms, or an alkynyl group having 2 to 5 carbon atoms; L³⁰¹ to L³⁰⁸ each independently represent a hydrogen atom, an alkyl group having 1 to 5 carbon atoms, an alkenyl group having 2 to 5 carbon atoms or an alkynyl group having 2 to 5 carbon atoms, but at least one of L³⁰¹ to L³⁰⁸ represents an alkyl group having 1 to 5 carbon atoms, an alkenyl group having 2 to 5 carbon atoms, or an alkynyl group having 2 to 5 carbon atoms; L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, but at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms; and n represents an integer of 9 or less.
[5] The method for producing a semiconductor substrate according to [1], wherein the solvent of the ester compound as the component [II] is a solvent represented by formula (L-4) below: 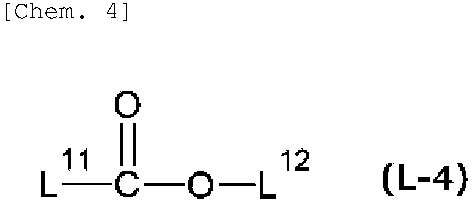 in the formula, L¹¹ and L¹² each independently represent an alkyl group having 1 to 6 carbon atoms, and a total of a number of carbon atoms in the alkyl group as L¹¹ and a number of carbon atoms in the alkyl group as L¹² is 7 or less.
[6] The method for producing a semiconductor substrate according to any one of [1] to [5], wherein the releasing and dissolving composition further contains a component [III]: a solvent of glycol ethers.
[7] The method for producing a semiconductor substrate according to [6], wherein the solvent of the glycol ethers as the component [III] is a solvent represented by formula (T) below: 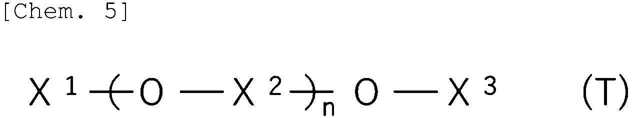 in the formula, X¹ and X³ each independently represent an alkyl group or an acyl group (X⁴-C(=O)-), X² represents an alkylene group, n represents 2 or 3. X⁴ represents an alkyl group.
[8] The method for producing a semiconductor substrate according to any one of [1] to [7], wherein the quaternary ammonium salt as the component [I] is a halogen-containing quaternary ammonium salt.
[9] The method for producing a semiconductor substrate according to any one of [1] to [8], wherein the amide-based solvent as the component [I] is an acid amide derivative represented by formula (Z) below or a compound represented by formula (Y) below: 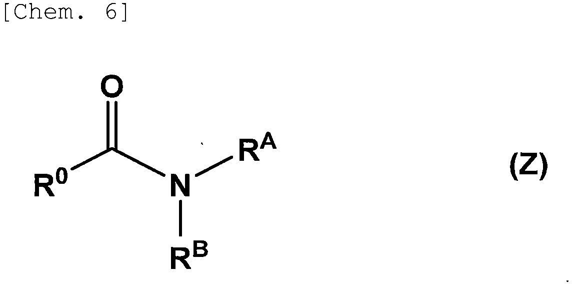
   in the formula, R⁰ represents an ethyl group, a propyl group, or an isopropyl group, and R^{A} and R^{B} each independently represent an alkyl group having 1 to 4 carbon atoms, 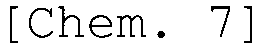 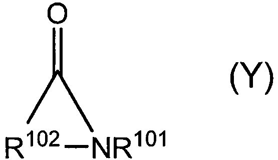
   in the formula, R¹⁰¹ represents a hydrogen atom or an alkyl group having 1 to 6 carbon atoms, and R¹⁰² represents an alkylene group having 1 to 6 carbon atoms or a group represented by formula (Y1) below, and 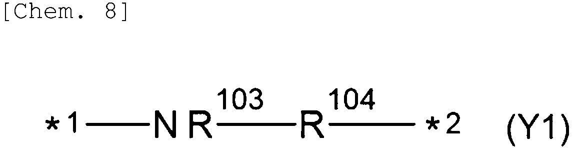
   in the formula, R¹⁰³ represents a hydrogen atom or an alkyl group having 1 to 6 carbon atoms, R¹⁰⁴ represents an alkylene group having 1 to 5 carbon atoms, *1 represents a bonding hand bonded to a carbon atom in formula (Y), and *2 represents a bonding hand bonded to a nitrogen atom in formula (Y).
[10] The method for producing a semiconductor substrate according to any one of [1] to [9], wherein the adhesive layer is a film obtained using an adhesive composition containing an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenol resin-based adhesive.
[11] The method for producing a semiconductor substrate according to [10], wherein the adhesive component (S) contains a siloxane-based adhesive.
[12] The method for producing a semiconductor substrate according to [11], wherein the siloxane-based adhesive contains a polyorganosiloxane component (A') that is cured by a hydrosilylation reaction.
[13] The method for producing a semiconductor substrate according to any one of [1] to [12], wherein the release and dissolution step includes a step of removing the released adhesive layer.
[14] A method for producing a processed semiconductor substrate, the processed semiconductor substrate being produced using the method for producing a semiconductor substrate according to [1], the method including:
   a first step of producing a laminate including a semiconductor substrate, a support substrate, and an adhesive layer obtained from an adhesive composition;
   a second step of processing the semiconductor substrate of the obtained laminate;
   a third step of separating the semiconductor substrate and the adhesive layer from the support substrate; and
   a fourth step that is the cleaning step defined in [1] of removing the adhesive layer on the semiconductor substrate by release and dissolution using the releasing and dissolving composition.
[15] A releasing and dissolving composition that is used to remove an adhesive layer on a semiconductor substrate by release and dissolution at a time of cleaning the semiconductor substrate,
   wherein the releasing and dissolving composition contains:
      a component [I]: a dissolution component containing a quaternary ammonium salt and an amide-based solvent, and
      a component [II]: a release component having a molecular weight of less than 160 and being composed of one or more solvents selected from an ether compound, a thioether compound, an aromatic hydrocarbon compound, an aliphatic hydrocarbon compound, an ester compound, and an amine compound, and
   a contact angle of the releasing and dissolving composition when the releasing and dissolving composition is added dropwise onto the adhesive layer disposed on the semiconductor substrate is more than 22.6 degrees and less than 46.1 degrees.
[16] The releasing and dissolving composition according to [15], wherein the solvent of the ether compound or the thioether compound as the component [II] is a solvent represented by formula (L-1) below:

   [Chem. 9] **L¹-L³-L²** (L- 1)

   in the formula, L¹ and L² each independently represent an alkyl group having 2 to 5 carbon atoms, and L³ represents O or S.
[17] The releasing and dissolving composition according to [15], wherein the solvent of the aromatic hydrocarbon compound as the component [II] is a solvent represented by formula (L-2) below: 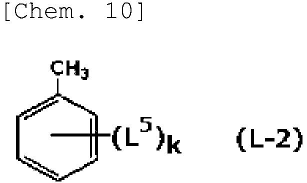 in the formula, L⁵' s represent a substituent substituted with a benzene ring and each independently represent an alkyl group having 1 to 4 carbon atoms, and k represents a number of L⁵ and is an integer of 0 to 5.
[18] The releasing and dissolving composition according to [15], wherein the solvent of the aliphatic hydrocarbon compound as the component [II] is a solvent represented by formulae (L-3-0) to (L-3-5) below: 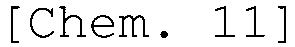 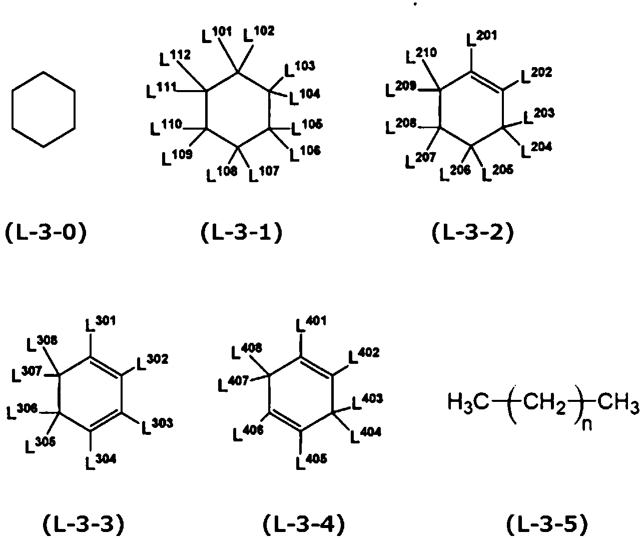 in the formulae, L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, but at least one of L¹⁰¹ to L¹¹² represents an alkyl group having 1 to 5 carbon atoms, an alkenyl group having 2 to 5 carbon atoms, or an alkynyl group having 2 to 5 carbon atoms; L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, but at least one of L²⁰¹ to L²¹⁰ represents an alkyl group having 1 to 5 carbon atoms, an alkenyl group having 2 to 5 carbon atoms, or an alkynyl group having 2 to 5 carbon atoms; L³⁰¹ to L³⁰⁸ each independently represent a hydrogen atom, an alkyl group having 1 to 5 carbon atoms, an alkenyl group having 2 to 5 carbon atoms or an alkynyl group having 2 to 5 carbon atoms, but at least one of L³⁰¹ to L³⁰⁸ represents an alkyl group having 1 to 5 carbon atoms, an alkenyl group having 2 to 5 carbon atoms, or an alkynyl group having 2 to 5 carbon atoms; L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, but at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms; and n represents an integer of 9 or less.
[19] The releasing and dissolving composition according to [15], wherein the solvent of the ester compound as the component [II] is a solvent represented by formula (L-4) below: 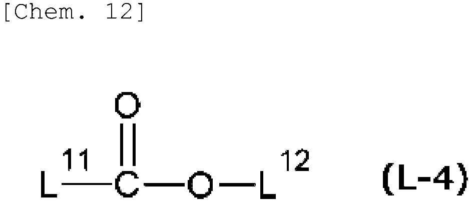 in the formula, L¹¹ and L¹² each independently represent an alkyl group having 1 to 6 carbon atoms, and a total of a number of carbon atoms in the alkyl group as L¹¹ and a number of carbon atoms in the alkyl group as L¹² is 7 or less.
[20] The releasing and dissolving composition according to any one of [15] to [19], wherein the releasing and dissolving composition further contains a component [III]: a solvent of glycol ethers.
[21] The releasing and dissolving composition according to [20], wherein the solvent of the glycol ethers as the component [III] is a solvent represented by formula (T) below: 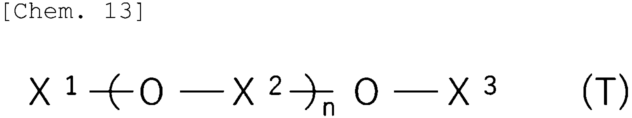 in the formula, X¹ and X³ each independently represent an alkyl group or an acyl group (X⁴-C(=O)-), X² represents an alkylene group, n represents 2 or 3. X⁴ represents an alkyl group.
[22] The releasing and dissolving composition according to any one of [15] to [21], wherein the quaternary ammonium salt as the component [I] is a halogen-containing quaternary ammonium salt.
[23] The releasing and dissolving composition according to any one of [15] to [22], wherein the amide-based solvent as the component [I] is an acid amide derivative represented by formula (Z) below or a compound represented by formula (Y) below: 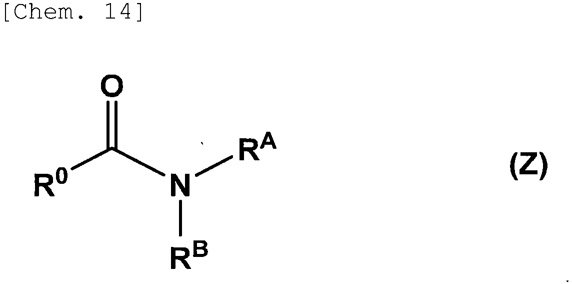
   in the formula, R⁰ represents an ethyl group, a propyl group, or an isopropyl group, and R^{A} and R^{B} each independently represent an alkyl group having 1 to 4 carbon atoms, 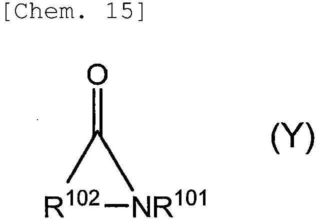
   in the formula, R¹⁰¹ represents a hydrogen atom or an alkyl group having 1 to 6 carbon atoms, and R¹⁰² represents an alkylene group having 1 to 6 carbon atoms or a group represented by formula (Y1) below, and 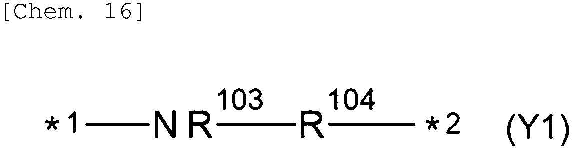
   in the formula, R¹⁰³ represents a hydrogen atom or an alkyl group having 1 to 6 carbon atoms, R¹⁰⁴ represents an alkylene group having 1 to 5 carbon atoms, *1 represents a bonding hand bonded to a carbon atom in formula (Y), and *2 represents a bonding hand bonded to a nitrogen atom in formula (Y).
[24] The releasing and dissolving composition according to any one of [15] to [23], wherein the adhesive layer is a film obtained using an adhesive composition containing an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenol resin-based adhesive.
[25] The releasing and dissolving composition according to [24], wherein the adhesive component (S) contains a siloxane-based adhesive.
[26] The releasing and dissolving composition according to [25], wherein the siloxane-based adhesive contains a polyorganosiloxane component (A') that is cured by a hydrosilylation reaction.

### Advantageous Effects of Invention

According to the present invention, it is possible to provide a method for producing a semiconductor substrate including a cleaning step of a semiconductor substrate, capable of removing (cleaning) an adhesive layer from a semiconductor substrate having the adhesive layer on a surface thereof more cleanly in a shorter time by a simple operation, a method for producing a processed semiconductor substrate including such a semiconductor production method, and a composition used in such a cleaning step.

### Description of Embodiments

Hereinafter, the present invention will be described in detail. Note that the description of the constituent requirements described below is an example for describing the present invention, and the present invention is not limited to the content thereof.

### (Method for producing semiconductor substrate)

The method for producing a semiconductor substrate of the present invention includes a step of releasing and dissolving an adhesive layer on a semiconductor substrate using a releasing and dissolving composition.

The releasing and dissolving composition contains:
a component [I]: a dissolution component containing a quaternary ammonium salt and an amide-based solvent, and
a component [II]: a release component having a molecular weight of less than 160 and being composed of one or more solvents selected from an ether compound, a thioether compound, an aromatic hydrocarbon compound, an aliphatic hydrocarbon compound, an ester compound, and an amine compound.

In addition, for the releasing and dissolving composition, in a case where the releasing and dissolving composition is added dropwise onto an adhesive layer disposed on a semiconductor substrate to obtain the contact angle of the releasing and dissolving composition, the contact angle is more than 22.6 degrees and less than 46.1 degrees.

The releasing and dissolving composition may further contain
a component [III]: a solvent of glycol ethers.

### <Semiconductor substrate>

The main material forming the entire semiconductor substrate is not particularly limited as long as it is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface. For example, the outer periphery of the semiconductor substrate may have a straight portion called an orientation flat or may have a cut called a notch.

The thickness of the disk-shaped semiconductor substrate may be appropriately determined according to the purpose of use of the semiconductor substrate and the like, and is not particularly limited, and is, for example, 500 to 1,000 µm.

The diameter of the disk-shaped semiconductor substrate may be appropriately determined according to the purpose of use of the semiconductor substrate and the like, and is not particularly limited, and is, for example, 100 to 1,000 mm.

The semiconductor substrate is, for example, a wafer, and specific examples thereof include, but are not limited to, a silicon wafer having a diameter of about 300 mm and a thickness of about 770 µm.

### <Adhesive layer>

The adhesive layer on the semiconductor substrate is, for example, a film obtained from an adhesive composition containing an adhesive component (S).

The adhesive component (S) is not particularly limited as long as it is used for this type of application, and examples thereof include a siloxane-based adhesive, an acrylic resin-based adhesive, an epoxy resin-based adhesive, a polyamide-based adhesive, a polystyrene-based adhesive, a polyimide adhesive, and a phenol resin-based adhesive.

Among them, the adhesive component (S) is preferably a siloxane-based adhesive, which exhibits a suitable adhesive ability during processing of a wafer or the like, can be suitably released after processing, and is excellent in heat resistance.

### <<Adhesive Composition>>

In a preferable aspect, the adhesive composition used in the present invention contains a component (A) that is cured by a hydrosilylation reaction as the adhesive component (S).

In addition, the adhesive composition used in the present invention contains a polyorganosiloxane in a preferable aspect.

The component (A) may be a component that is cured by a hydrosilylation reaction, or may be a polyorganosiloxane component (A') that is cured by a hydrosilylation reaction.

In another preferable aspect, the component (A) contains, for example, as an example of the component (A'), a polyorganosiloxane (a1) having an alkenyl group having 2 to 40 carbon atoms bonded to a silicon atom, a polyorganosiloxane (a2) having a Si-H group, and a platinum group metal-based catalyst (A2). Here, the alkenyl group having 2 to 40 carbon atoms may be optionally substituted. Examples of the substituent include a halogen atom, a nitro group, a cyano group, an amino group, a hydroxy group, a carboxyl group, an aryl group, and a heteroaryl group.

In another preferable aspect, the polyorganosiloxane component (A') that is cured by a hydrosilylation reaction includes a polysiloxane (A1) containing one or two or more units selected from the group consisting of a siloxane unit (Q unit) represented by SiO₂, a siloxane unit (M unit) represented by R¹R²R³SiO_{1/2}, a siloxane unit (D unit) represented by R⁴R⁵SiO_{2/2}, and a siloxane unit (T unit) represented by R⁶SiO_{3/2}, and a platinum group metal-based catalyst (A2). The polysiloxane (A1) includes: a polyorganosiloxane (a1') containing one or two or more units selected from the group consisting of a siloxane unit (Q' unit) represented by SiO₂, a siloxane unit (M' unit) represented by R¹'R²'R³'SiO_{1/2}, a siloxane unit (D' unit) represented by R⁴' R⁵' SiO_{2/2}, and a siloxane unit (T' unit) represented by R⁶'SiO_{3/2}, and also containing at least one selected from the group consisting of M' unit, D' unit, and T' unit, and a polyorganosiloxane (a2') containing one or two or more units selected from the group consisting of a siloxane unit (Q'' unit) represented by SiO₂, a siloxane unit (M'' unit) represented by R¹''R²''R³''SiO_{1/2}, a siloxane unit (D'' unit) represented by R⁴''R⁵''SiO_{2/2}, and a siloxane unit (T'' unit) represented by R⁶''SiO_{3/2}, and also containing at least one selected from the group consisting of M'' unit, D'' unit, and T'' unit.

Note that (a1') is an example of (a1), and (a2') is an example of (a2).

R¹ to R⁶ are groups or atoms bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, and a heteroaryl group.

R¹' to R⁶' are groups bonded to a silicon atom and each independently represent an optionally substituted alkyl group or an optionally substituted alkenyl group, provided that at least one of R¹' to R⁶' is an optionally substituted alkenyl group. Examples of the substituent include a halogen atom, a nitro group, a cyano group, an amino group, a hydroxy group, a carboxyl group, an aryl group, and a heteroaryl group.

R¹'' to R⁶" are groups or atoms bonded to a silicon atom, and each independently represent an optionally substituted alkyl group or a hydrogen atom, provided that at least one of R¹'' to R⁶'' is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, and is preferably a linear or branched alkyl group. The number of carbon atoms thereof is not particularly limited, and is ordinarily 1 to 40, preferably 30 or less, more preferably 20 or less, and still more preferably 10 or less.

Specific examples of the optionally substituted linear or branched alkyl group include a methyl group, an ethyl group, an n-propyl group, an i-propyl group, an n-butyl group, an i-butyl group, an s-butyl group, a tertiary butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group, but are not limited thereto, and the number of carbon atoms thereof is ordinarily 1 to 14, preferably 1 to 10, and more preferably 1 to 6. Among them, a methyl group is particularly preferable.

Specific examples of the optionally substituted cyclic alkyl group include a cycloalkyl group such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group; and a bicycloalkyl group such as a bicyclobutyl group, a bicyclopentyl group, a bicyclohexyl group, a bicycloheptyl group, a bicyclooctyl group, a bicyclononyl group, and a bicyclodecyl group, but are not limited thereto, and the number of carbon atoms thereof is ordinarily 3 to 14, preferably 4 to 10, and more preferably 5 to 6.

The alkenyl group may be a linear or branched alkenyl group, and the number of carbon atoms thereof is not particularly limited, and is ordinarily 2 to 40, preferably 30 or less, more preferably 20 or less, and still more preferably 10 or less.

Specific examples of the optionally substituted linear or branched alkenyl group include, but are not limited to, a vinyl group, an allyl group, a butenyl group, and a pentenyl group. The number of carbon atoms thereof is ordinarily 2 to 14, preferably 2 to 10, and more preferably 1 to 6. Among them, an ethenyl group and a 2-propenyl group are particularly preferable.

Specific examples of the optionally substituted cyclic alkenyl group include, but are not limited to, cyclopentenyl and cyclohexenyl, and the number of carbon atoms thereof is ordinarily 4 to 14, preferably 5 to 10, and more preferably 5 to 6.

As described above, the polysiloxane (A1) contains the polyorganosiloxane (a1') and the polyorganosiloxane (a2'), and an alkenyl group contained in the polyorganosiloxane (a1') and a hydrogen atom (Si-H group) contained in the polyorganosiloxane (a2') form a crosslinked structure through a hydrosilylation reaction by the platinum group metal-based catalyst (A2) to cause curing. As a result, a cured film is formed.

The polyorganosiloxane (a1') contains one or two or more units selected from the group consisting of a Q' unit, an M' unit, a D' unit, and a T' unit, and contains at least one selected from the group consisting of an M' unit, a D' unit, and a T' unit. As the polyorganosiloxane (a1'), two or more types of polyorganosiloxanes satisfying such conditions may be used in combination.

Examples of preferable combinations of two or more types selected from the group consisting of a Q' unit, an M' unit, a D' unit, and a T' unit include, but are not limited to, (Q' unit and M' unit), (D' unit and M' unit), (T' unit and M' unit), and (Q' unit, T' unit, and M' unit).

In addition, when two or more types of polyorganosiloxanes included in the polyorganosiloxane (a1') are contained, a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferable, but the combinations are not limited thereto.

The polyorganosiloxane (a2') contains one or two or more units selected from the group consisting of a Q'' unit, an M'' unit, a D'' unit, and a T'' unit, and contains at least one selected from the group consisting of an M'' unit, a D" unit, and a T'' unit. As the polyorganosiloxane (a2'), two or more types of polyorganosiloxanes satisfying such conditions may be used in combination.

Examples of preferable combinations of two or more selected from the group consisting of a Q" unit, an M'' unit, a D'' unit, and a T'' unit include, but are not limited to, (M'' unit and D'' unit), (Q'' unit and M" unit), and (Q'' unit, T'' unit, and M'' unit).

The polyorganosiloxane (a1') is composed of siloxane units in which alkyl groups and/or alkenyl groups are bonded to silicon atoms of the polyorganosiloxane, and the proportion of alkenyl groups in all substituents represented by R¹' to R⁶' is preferably 0.1 to 50.0 mol%, more preferably 0.5 to 30.0 mol%, and the remaining R¹' to R⁶' can be alkyl groups.

The polyorganosiloxane (a2') is composed of siloxane units in which alkyl groups and/or hydrogen atoms are bonded to silicon atoms of the polyorganosiloxane, and the proportion of hydrogen atoms in all substituents and substitutional atoms represented by R¹'' to R⁶" is preferably 0.1 to 50.0 mol%, more preferably 10.0 to 40.0 mol%, and the remaining R¹'' to R⁶'' can be alkyl groups.

When the component (A) contains (a1) and (a2), in a preferable aspect of the present invention, the molar ratio of the alkenyl group contained in the polyorganosiloxane (a1) and the hydrogen atom constituting the Si-H bond contained in the polyorganosiloxane (a2) is in the range of 1.0:0.5 to 1.0:0.66.

The weight average molecular weight of the polysiloxane such as the polyorganosiloxane (a1) or the polyorganosiloxane (a2) is not particularly limited, but each is typically 500 to 1,000,000, and is preferably 5,000 to 50,000 from the viewpoint of achieving the effects of the present invention with good reproducibility.

In the present invention, the weight average molecular weight, the number average molecular weight, and the dispersity of the polyorganosiloxanes can be measured, for example, using a GPC apparatus (EcoSEC, HLC-8320GPC, manufactured by Tosoh Corporation) and a GPC column (TSKgel SuperMultipore HZ-N and TSKgel SuperMultipore HZ-H, manufactured by Tosoh Corporation), at a column temperature of 40°C, using tetrahydrofuran as an eluent (elution solvent), at a flow amount (flow rate) of 0.35 mL/min, and using polystyrene (Shodex from Showa Denko K.K.) as a standard sample.

The viscosity of each of the polyorganosiloxane (a1) and the polyorganosiloxane (a2) is not particularly limited, and is usually 10 to 1,000,000 (mPa·s), and is preferably 50 to 20,000 (mPa·s) from the viewpoint of realizing the effects of the present invention with good reproducibility. The viscosity of the polyorganosiloxane (a1) and the polyorganosiloxane (a2) are values measured with an E-type rotational viscometer at 25°C.

The polyorganosiloxane (a1) and the polyorganosiloxane (a2) react with each other by a hydrosilylation reaction to form a film. Accordingly, the mechanism of curing is different from a mechanism, for example, through silanol groups, and therefore, any siloxane does not need to contain a silanol group or a functional group that forms a silanol group by hydrolysis, such as an alkyloxy group.

In a preferable aspect of the present invention, the adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, platinum-based catalysts such as platinum black, second platinum chloride, chloroplatinic acid, a reaction product of chloroplatinic acid and monohydric alcohol, a complex of chloroplatinic acid and olefins, and platinum bisacetoacetate.

Examples of the complex of platinum and olefins include, but are not limited to, a complex of divinyltetramethyldisiloxane and platinum.

The amount of the platinum group metal-based catalyst (A2) is not particularly limited, but is usually in the range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of suppressing the progress of the hydrosilylation reaction.

The polymerization inhibitor is not particularly limited as long as the polymerization inhibitor can suppress the progress of the hydrosilylation reaction, and specific examples thereof include alkynyl alcohols such as 1-ethynyl-1-cyclohexanol and 1,1-diphenyl-2-propion-1-ol.

The amount of the polymerization inhibitor is not particularly limited, but is usually 1,000.0 ppm or more with respect to the total amount of the polyorganosiloxane (a1) and the polyorganosiloxane (a2) from the viewpoint of obtaining the effect, and is 10,000.0 ppm or less from the viewpoint of preventing excessive suppression of the hydrosilylation reaction.

The adhesive composition used in the present invention may contain a release agent component (B). By including such a release agent component (B) in the adhesive composition used in the present invention, the obtained adhesive layer can be suitably released with good reproducibility.

Typical examples of the release agent component (B) include a polyorganosiloxane. In a preferable aspect, specific examples thereof include, but are not limited to, an epoxy group-containing polyorganosiloxane, a methyl group-containing polyorganosiloxane, and a phenyl group-containing polyorganosiloxane.

In another preferable aspect, examples of the release agent component (B) include polydimethylsiloxane, and the polydimethylsiloxane may be modified. Examples of the optionally modified polydimethylsiloxane includes, but are not limited to, an epoxy group-containing polydimethylsiloxane, an unmodified polydimethylsiloxane, or a phenyl group-containing polydimethylsiloxane.

The weight average molecular weight of the polyorganosiloxane as the release agent component (B) is not particularly limited, and is usually 100,000 to 2,000,000, and is preferably 200,000 to 1,200,000, and more preferably 300,000 to 900,000 from the viewpoint of realizing the effects of the present invention with good reproducibility. In addition, the dispersity is not particularly limited, and is usually 1.0 to 10.0, and is preferably 1.5 to 5.0, and more preferably 2.0 to 3.0 from the viewpoint of realizing suitable release with good reproducibility, and the like. The weight average molecular weight and the dispersity can be measured by the above-described method related to the polysiloxane.

The complex viscosity of the polyorganosiloxane as the release agent component (B) can be measured at 25°C using a rheometer (for example, Rheometer MCR-302 manufactured by Anton Paar GmbH).

Examples of the epoxy group-containing polyorganosiloxane include those containing a siloxane unit (D¹⁰ unit) represented by R¹¹R¹²SiO_{2/2}.

R¹¹ is a group bonded to a silicon atom and represents an alkyl group, R¹² is a group bonded to a silicon atom and represents an epoxy group or an organic group containing an epoxy group, and specific examples of the alkyl group include the above-described examples.

The epoxy group in the epoxy group-containing organic group may be an independent epoxy group without being fused to another ring, or may be an epoxy group forming a fused ring with another ring, such as a 1,2-epoxycyclohexyl group.

Specific examples of the organic group containing an epoxy group include, but are not limited to, 3-glycidoxypropyl and 2-(3,4-epoxycyclohexyl)ethyl.

In the present invention, preferable examples of the epoxy group-containing polyorganosiloxane may include, but are not limited to, an epoxy group-containing polydimethylsiloxane.

The epoxy group-containing polyorganosiloxane contains the above-described siloxane unit (D¹⁰ unit), but may contain Q unit, M unit, and/or T unit in addition to D¹⁰ unit.

In a preferable aspect of the present invention, specific examples of the epoxy group-containing polyorganosiloxane include a polyorganosiloxane composed only of D¹⁰ units, a polyorganosiloxane containing D¹⁰ units and Q units, a polyorganosiloxane containing D¹⁰ units and M units, a polyorganosiloxane containing D¹⁰ units and T units, a polyorganosiloxane containing D¹⁰ units, Q units, and M units, a polyorganosiloxane containing D¹⁰ units, M units, and T units, or a polyorganosiloxane containing D¹⁰ units, Q units, M units, and T units.

The epoxy group-containing polyorganosiloxane is preferably an epoxy group-containing polydimethylsiloxane having an epoxy value of 0.1 to 5. In addition, the weight average molecular weight thereof is not particularly limited, and is usually from 1,500 to 500,000, and is preferably 100,000 or less from the viewpoint of preventing precipitation in the adhesive.

Specific examples of the epoxy group-containing polyorganosiloxane include, but are not limited to, those represented by formulae (E1) to (E3). 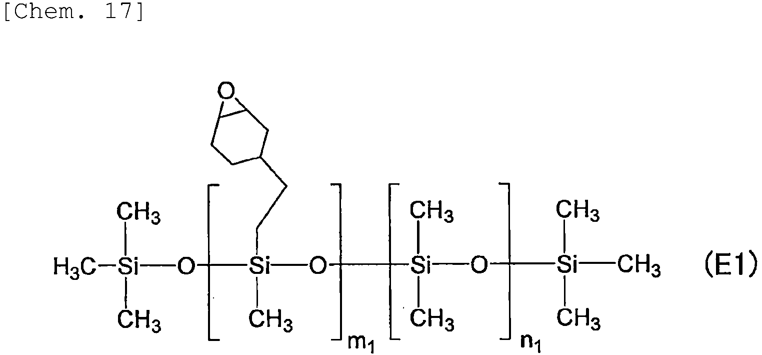 m₁ and n₁ represent the number of respective repeating units, and are positive integers. 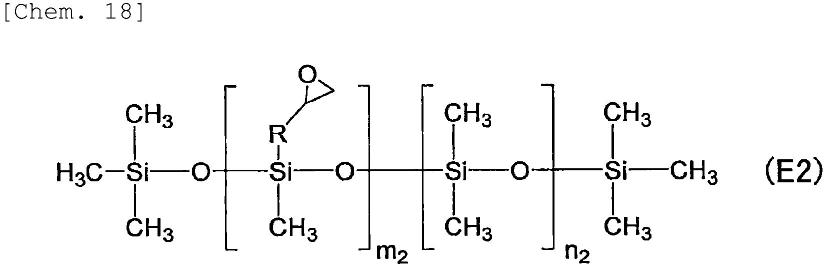 m₂ and n₂ each represent the number of repeating units and are positive integers, and R is an alkylene group having 1 to 10 carbon atoms. 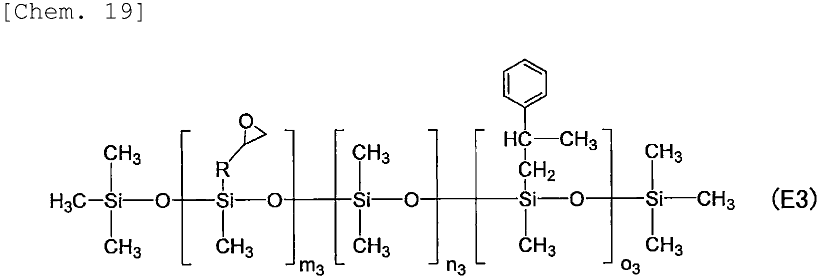 m₃, n₃, and o₃ each represent the number of repeating units and are positive integers, and R is an alkylene group having 1 to 10 carbon atoms.

Examples of the methyl group-containing polyorganosiloxane include those containing a siloxane unit (D²⁰⁰ unit) represented by R²¹⁰R²²⁰SiO_{2/2}, and preferably those containing a siloxane unit (D²⁰ unit) represented by R²¹R²¹SiO_{2/2}.

R²¹⁰ and R²²⁰ are groups bonded to silicon atoms, and each independently represent an alkyl group, but at least one thereof is a methyl group, and specific examples of the alkyl group include the above-described examples.

R²¹ is a group bonded to a silicon atom and represents an alkyl group, and specific examples of the alkyl group include the above-described examples. Among them, a methyl group is preferable as R²¹.

In the present invention, preferable examples of the methyl group-containing polyorganosiloxane may include, but are not limited to, a polydimethylsiloxane.

The methyl group-containing polyorganosiloxane contains the above-described siloxane unit (D²⁰⁰ unit or D²⁰ unit), but may contain Q unit, M unit, and/or T unit in addition to D²⁰⁰ unit and D²⁰ unit.

In an aspect of the present invention, specific examples of the methyl group-containing polyorganosiloxane include a polyorganosiloxane composed only of D²⁰⁰ units, a polyorganosiloxane containing D²⁰⁰ units and Q units, a polyorganosiloxane containing D²⁰⁰ units and M units, a polyorganosiloxane containing D²⁰⁰ units and T units, a polyorganosiloxane containing D²⁰⁰ units, Q units, and M units, a polyorganosiloxane containing D²⁰⁰ units, M units, and T units, or a polyorganosiloxane containing D²⁰⁰ units, Q units, M units, and T units.

In a preferable aspect of the present invention, specific examples of the methyl group-containing polyorganosiloxane include a polyorganosiloxane composed only of D²⁰ units, a polyorganosiloxane containing D²⁰ units and Q units, a polyorganosiloxane containing D²⁰ units and M units, a polyorganosiloxane containing D²⁰ units and T units, a polyorganosiloxane containing D²⁰ units, Q units, and M units, a polyorganosiloxane containing D²⁰ units, M units, and T units, or a polyorganosiloxane containing D²⁰ units, Q units, M units, and T units.

Specific examples of the methyl group-containing polyorganosiloxane include, but are not limited to, those represented by formula (M1). 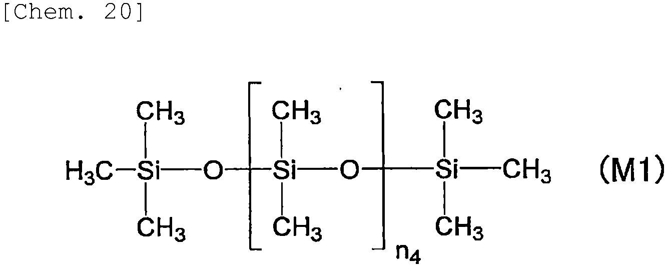 n₄ represents the number of repeating units, and is a positive integer.

Examples of the phenyl group-containing polyorganosiloxane include those containing a siloxane unit (D³⁰ unit) represented by R³¹R³²SiO_{2/2}.

R³¹ is a group bonded to a silicon atom and represents a phenyl group or an alkyl group, R³² is a group bonded to a silicon atom and represents a phenyl group, and specific examples of the alkyl group include the above-described examples, but a methyl group is preferable.

The phenyl group-containing polyorganosiloxane contains the above-described siloxane unit (D³⁰ unit), but may contain Q unit, M unit, and/or T unit in addition to D³⁰ unit.

In a preferable aspect of the present invention, specific examples of the phenyl group-containing polyorganosiloxane include a polyorganosiloxane composed only of D³⁰ units, a polyorganosiloxane containing D³⁰ units and Q units, a polyorganosiloxane containing D³⁰ units and M units, a polyorganosiloxane containing D³⁰ units and T units, a polyorganosiloxane containing D³⁰ units, Q units, and M units, a polyorganosiloxane containing D³⁰ units, M units, and T units, or a polyorganosiloxane containing D³⁰ units, Q units, M units, and T units.

Specific examples of the phenyl group-containing polyorganosiloxane include, but are not limited to, those represented by formula (P1) or (P2). 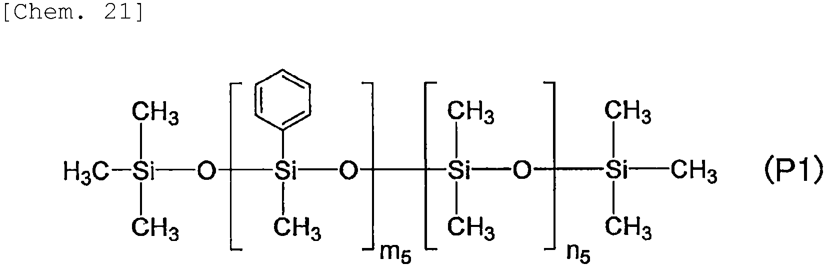 m₅ and n₅ represent the number of respective repeating units, and are positive integers. 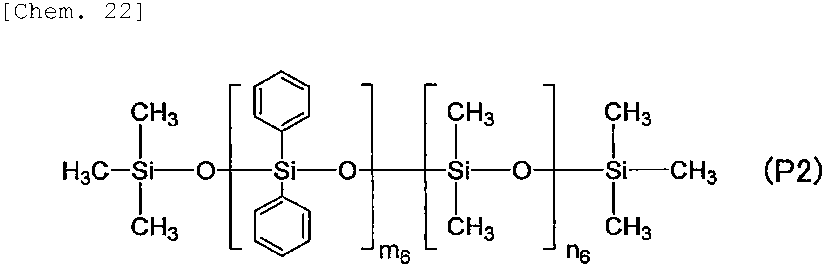 m₆ and n₆ represent the number of respective repeating units, and are positive integers.

The polyorganosiloxane as the release agent component (B) may be a commercially available product or a synthetic product.

Examples of commercially available products of the polyorganosiloxane include, but are not limited to, Wacker Silicone Fluid AK series (AK 50, AK 350, AK 1000, AK 10000, AK 1000000) and GENIOPLAST GUM, which are products manufactured by Wacker Chemie AG, dimethyl silicone oil (KF-96L, KF-96A, KF-96, KF-96H, KF-69, KF-965, KF-968) and cyclic dimethyl silicone oil (KF-995) manufactured by Shin-Etsu Chemical Co., Ltd.; epoxy group-containing polyorganosiloxane manufactured by Gelest, Inc. (trade name: CMS-227, ECMS-327), epoxy group-containing polyorganosiloxane manufactured by Shin-Etsu Chemical Co., Ltd. (KF-101, KF-1001, KF-1005, X-22-343), epoxy group-containing polyorganosiloxane (BY16-839) manufactured by Dow Corning Corporation; and phenyl group-containing polyorganosiloxane (PMM-1043, PMM-1025, PDM-0421, PDM-0821) manufactured by Gelest, Inc., phenyl group-containing polyorganosiloxane (KF50-3000CS) manufactured by Shin-Etsu Chemical Co., Ltd., and phenyl group-containing polyorganosiloxane (TSF431, TSF433) manufactured by Momentive Performance Materials, Inc.

The adhesive composition used in the present invention contains the release agent component (B) together with the component (A) that is cured, and in a more preferable aspect, a polyorganosiloxane is contained as the release agent component (B).

In an example of the adhesive composition used in the present invention, the component (A) that is cured and the release agent component (B) can be contained in any ratio, but in consideration of the balance between adhesiveness and releasability, the ratio of the component (A) that is cured and the release agent component (B) is preferably 99.995:0.005 to 30:70, and more preferably 99.9:0.1 to 75:25 in mass ratio [(A):(B)].

That is, when the polyorganosiloxane component (A') that is cured by a hydrosilylation reaction is contained, the ratio of the component (A') to the release agent component (B) is preferably 99.995:0.005 to 30:70, and more preferably 99.9:0.1 to 75:25 in mass ratio [(A'):(B)].

The adhesive composition used in the present invention may contain a solvent for the purpose of, for example, adjusting the viscosity, and specific examples thereof include, but are not limited to, aliphatic hydrocarbon, aromatic hydrocarbon, and ketone.

More specific examples of the solvent include, but are not limited to, hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, and 5-nonanone. As such a solvent, one type can be used alone or two or more types can be used in combination.

When the adhesive composition used in the present invention contains a solvent, the content thereof is appropriately set in consideration of the desired viscosity of the composition, the coating method to be employed, the thickness of a thin film to be prepared, and the like, and is in the range of about 10 to 90 mass% with respect to the entire composition.

The viscosity of the adhesive composition used in the present invention is not particularly limited, and is usually 500 to 20,000 mPa·s, and preferably 1,000 to 5,000 mPa·s at 25°C. The viscosity of the adhesive composition used in the present invention can be adjusted by changing the type of solvent to be used, the ratio thereof, the concentration of the film constituent components, and the like, in consideration of various factors such as the coating method to be used and the desired film thickness.

In the present invention, the term "film constituent components" means components other than a solvent contained in the composition.

In an example of the adhesive composition used in the present invention, the adhesive composition can be produced by mixing the component (A) with the release agent component (B) and a solvent when used.

The mixing order is not particularly limited, and examples of the method capable of producing the adhesive composition for release easily with good reproducibility include, but are not limited to, a method in which the component (A) and the release agent component (B) are dissolved in a solvent, and a method in which the component (A) and the release agent component (B) are partially dissolved in a solvent, the rest are dissolved in a solvent, and the resulting solutions are mixed. Note that when the adhesive composition is prepared, the components may be heated, if appropriate, as long as the components are not decomposed or altered.

In the present invention, for the purpose of removing foreign matter, a solvent, a solution, or the like to be used may be filtered using a filter or the like during the manufacturing of the adhesive composition or after mixing all the components.

The thickness of the adhesive layer is not particularly limited, but is preferably 10 to 100 µm and more preferably 20 to 50 µm from the viewpoint of obtaining a good releasing effect with good reproducibility.

### <Releasing and dissolving composition>

The releasing and dissolving composition is a composition used for a method for producing a semiconductor substrate in order to remove an adhesive layer from the semiconductor substrate.

The releasing and dissolving composition contains a release component for releasing the adhesive layer from the semiconductor substrate by swelling the adhesive layer, and a dissolution component for dissolving the adhesive layer.

Specifically, the releasing and dissolving composition contains:
a component [I]: a dissolution component containing a quaternary ammonium salt and an amide-based solvent, and
a component [II]: a release component having a molecular weight of less than 160 and being composed of one or more solvents selected from an ether compound, a thioether compound, an aromatic hydrocarbon compound, an aliphatic hydrocarbon compound, an ester compound, and an amine compound.

The releasing and dissolving composition may further contain a component [III]: a solvent of glycol ethers.

For the releasing and dissolving composition, in a case where the releasing and dissolving composition is added dropwise onto an adhesive layer disposed on a semiconductor substrate to obtain the contact angle of the releasing and dissolving composition, the contact angle is more than 22.6 degrees and less than 46.1 degrees.

### <<Component [I]>>

The component [I] refers to a dissolution component containing a quaternary ammonium salt and an amide-based solvent.

### <<<Component [I-1]: Quaternary ammonium salt>>>

The quaternary ammonium salt is composed of a quaternary ammonium cation and an anion, and is not particularly limited as long as the quaternary ammonium salt is used for this type of application.

The quaternary ammonium salt is effective as a component for dissolving the adhesive layer.

Typical examples of such a quaternary ammonium cation include a tetra (hydrocarbon) ammonium cation. On the other hand, examples of an anion paired therewith include, but are not limited to, a hydroxide ion (OH⁻); a halogen ion such as a fluorine ion (F⁻), a chlorine ion (Cl⁻), a bromine ion (Br⁻), and an iodine ion (I⁻); a tetrafluoroborate ion (BF₄⁻); or a hexafluorophosphate ion (PF₆⁻).

The quaternary ammonium salt is preferably a halogen-containing quaternary ammonium salt, and more preferably a fluorine-containing quaternary ammonium salt.

In the quaternary ammonium salt, the halogen atom may be contained in the cation or the anion, but is preferably contained in the anion.

In a preferable aspect, the fluorine-containing quaternary ammonium salt is tetra (hydrocarbon) ammonium fluoride.

Specific examples of the hydrocarbon group in tetra(hydrocarbon)ammonium fluoride include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferable aspect, the tetra(hydrocarbon)ammonium fluoride includes tetraalkylammonium fluoride.

Specific examples of tetraalkylammonium fluoride include, but are not limited to, tetramethylammonium fluoride, tetraethylammonium fluoride, tetrapropylammonium fluoride, and tetrabutylammonium fluoride. Among them, tetrabutylammonium fluoride is preferable.

As the quaternary ammonium salt such as tetra(hydrocarbon)ammonium fluoride, a hydrate may be used. In addition, as the quaternary ammonium salt such as tetra(hydrocarbon)ammonium fluoride, one type may be used alone or two or more types may be used in combination.

The amount of the quaternary ammonium salt is not particularly limited as long as the quaternary ammonium salt is dissolved in the solvent contained in the releasing and dissolving composition, but the quaternary ammonium salt is preferably contained in a small amount because the problem of damage to a dicing tape in a cleaning step described later can be effectively prevented. Specifically, for example, the amount is usually 0.1 to 5 mass% with respect to the releasing and dissolving composition.

### <<<Component [I-2]: Amide-based solvent>>>

The amide-based solvent is effective as a component for obtaining a releasing and dissolving composition excellent in uniformity by dissolving the quaternary ammonium salt well.

The amide-based solvent is preferably an N-substituted amide compound having 4 or more carbon atoms and having no active hydrogen on the nitrogen atom.

Suitable examples of the amide-based solvent include an acid amide derivative represented by formula (Z) below.

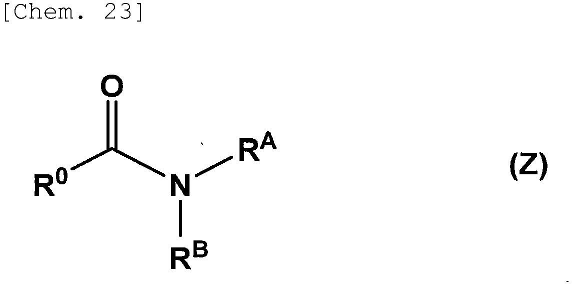

In the formula, R⁰ represents an ethyl group, a propyl group or an isopropyl group, and is preferably an ethyl group or an isopropyl group, and more preferably an ethyl group. R^{A} and R^{B} each independently represent an alkyl group having 1 to 4 carbon atoms. The alkyl group having 1 to 4 carbon atoms may be linear, branched, or cyclic, and specific examples thereof include a methyl group, an ethyl group, a propyl group, an isopropyl group, a cyclopropyl group, a n-butyl group, an isobutyl group, a s-butyl group, a t-butyl group, and a cyclobutyl group. Among them, R^{A} and R^{B} are preferably a methyl group or an ethyl group, more preferably a methyl group or an ethyl group, and still more preferably a methyl group.

Examples of the acid amide derivative represented by formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, or N-ethyl-N-methylisobutyramide. Among them, N,N-dimethylpropionamide and N,N-dimethylisobutyramide are particularly preferable, and N,N-dimethylpropionamide is more preferable.

The acid amide derivative represented by formula (Z) may be synthesized by a substitution reaction between a corresponding carboxylic acid ester and an amine, or a commercially available product may be used.

Another example of the preferable amide-based solvent is a compound represented by formula (Y) containing a lactam compound or the like.

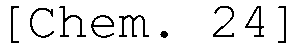

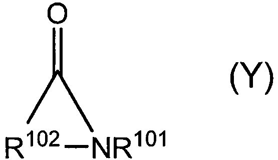

In formula (Y), R¹⁰¹ represents a hydrogen atom or an alkyl group having 1 to 6 carbon atoms, and R¹⁰² represents an alkylene group having 1 to 6 carbon atoms or a group represented by formula (Y1) below.

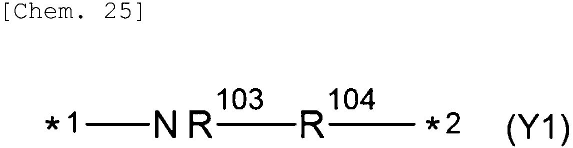

Specific examples of the alkyl group having 1 to 6 carbon atoms of R¹⁰² include a methyl group, an ethyl group, a n-propyl group, and a n-butyl group, and specific examples of the alkylene group having 1 to 6 carbon atoms include a methylene group, an ethylene group, a trimethylene group, a tetramethylene group, a pentamethylene group, and a hexamethylene group, but are not limited thereto.

In formula (Y1), R¹⁰³ represents a hydrogen atom or an alkyl group having 1 to 6 carbon atoms, R¹⁰⁴ represents an alkylene group having 1 to 5 carbon atoms, *1 represents a bonding hand bonded to a carbon atom in formula (Y), and *2 represents a bonding hand bonded to a nitrogen atom in formula (Y).

Specific examples of the lactam compound represented by formula (Y) may include an α-lactam compound, a β-lactam compound, a γ-lactam compound, and a δ-lactam compound, and these compounds can be used alone or in combination of two or more thereof.

In a preferable aspect, the lactam compound represented by formula (Y) contains 1-alkyl-2 pyrrolidone (N-alkyl-γ-butyrolactam), in a more preferable aspect, N-methylpyrrolidone (NMP) or N-ethylpyrrolidone (NEP), and in a still more preferable aspect, N-methylpyrrolidone (NMP).

In addition, as a preferable aspect of the compound represented by formula (Y), for example, 1,3-dimethyl-2-imidazolidinone can also be mentioned.

Among the components [I-2], it is more preferable to use the acid amide derivative represented by formula (Z) in consideration of the operational restriction based on the regulations on use for chemical substances.

The content of the amide-based solvent in the releasing and dissolving composition can be set to 70 mass% or less with respect to 100 mass% of aprotic solvents in the releasing and dissolving composition.

In addition, the content of the amide-based solvent is preferably 10 to 55 mass%, more preferably 20 to 50 mass%, still more preferably 20 to 45 mass%, and particularly preferably 20 to 40 mass% with respect to 100 mass% of the aprotic solvent.

In the present invention, the content of the solvent to be mixed is defined by the ratio with respect to 100 mass% of aprotic solvents that are solvents having no hydroxy group (-OH).

Thus, protic solvents such as water, methanol, and 1-methoxy-2-propanol are not included in the criteria of the content ratio.

In the present invention, the aprotic solvents refer to, for example, N,N-dimethylpropionamide, dibutyl ether, dipropylene glycol dimethyl ether, dibutyl acetate, and the like, and the mixing ratio can be determined based on the total amount thereof.

### <<Component [II]>>

The component [II] refers to a release component having a molecular weight of less than 160 and being composed of one or more solvents selected from an ether compound, a thioether compound, an aromatic hydrocarbon compound, an aliphatic hydrocarbon compound, an ester compound, and an amine compound.

### <<<Component [II-1]: Solvent of ether compound or thioether compound>>>

The solvent of the ether compound or the thioether compound is preferably a solvent represented by formula (L-1) below.

The solvent represented by formula (L-1) below is effective as a release component for swelling the adhesive layer and releasing the adhesive layer from the semiconductor substrate.

[Chem. 26] **L¹-L³-L² (L-1)**

In formula (L-1), L¹ and L² each independently represent an alkyl group having 2 to 5 carbon atoms, and L³ represents O or S.

L¹ and L² may be the same group or different groups, but are preferably the same group from the viewpoint of availability.

The alkyl group having 2 to 5 carbon atoms may be linear, branched, or cyclic, but is preferably a linear or branched alkyl group, and more preferably linear from the viewpoint of realizing release of the adhesive layer in a short time with good reproducibility, and the like.

Specific examples of the linear or branched alkyl group include, but are not limited to, an ethyl group, a n-propyl group, an i-propyl group, a n-butyl group, an i-butyl group, an s-butyl group, a t-butyl group, and a n-pentyl group.

Specific examples of the cyclic alkyl group include, but are not limited to, a cyclopropyl group, a cyclobutyl group, a 1-methyl-cyclopropyl group, a 2-methyl-cyclopropyl group, and a cyclopentyl group.

From the viewpoint of realizing release of the adhesive layer in a short time with good reproducibility, the alkyl group having 2 to 5 carbon atoms is preferably an ethyl group, a n-propyl group, a n-butyl group, or a n-pentyl group, and more preferably an ethyl group, a n-propyl group, or a n-butyl group.

From the viewpoint of realizing release of the adhesive layer in a shorter time with good reproducibility, the viewpoint of easy availability of the compound, and the like, L¹ and L² are preferably the same group.

Preferable examples of the organic solvent represented by formula (L-1) include di(n-butyl) ether, diethyl ether, di(n-pentyl) ether, di(n-propyl) sulfide, dibutyl sulfide, and the like from the viewpoint of realizing release of the adhesive layer in a shorter time with good reproducibility, the viewpoint of easy availability of the compound, and the like.

The content of the solvent represented by formula (L-1) in the releasing and dissolving composition can be set to 30 mass% or more with respect to 100 mass% of aprotic solvents in the releasing and dissolving composition.

The content of the solvent represented by formula (L-1) or the like in the releasing and dissolving composition is preferably 30 mass% or more, more preferably 31 mass% or more, still more preferably 40 mass% or more, and preferably 90 mass% or less, more preferably 80 mass% or less with respect to 100 mass% of aprotic solvents in the releasing and dissolving composition. Any combination of these upper and lower limit values may be used. Therefore, the content of the solvent represented by formula (L-1) is preferably 30 to 90 mass% and more preferably 40 to 80 mass% with respect to 100 mass% of aprotic solvents in the releasing and dissolving composition.

### <<<Component [II-2]: Solvent of aromatic hydrocarbon compound>>>

The solvent of the aromatic hydrocarbon compound is preferably a solvent represented by formula (L-2) below.

The solvent represented by formula (L-2) below is effective as a release component for swelling the adhesive layer and releasing the adhesive layer from the semiconductor substrate.

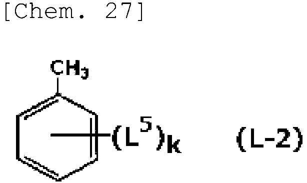

In formula (L-2), L⁵'s represent a substituent substituted with a benzene ring, each independently represents an alkyl group having 1 to 4 carbon atoms, and k represents the number of L⁵'s and is an integer of 0 to 5.

The alkyl group may be a linear, branched, or cyclic alkyl group, but is preferably a linear or branched alkyl group.

Specific examples of the linear or branched alkyl group include, but are not limited to, a methyl group, an ethyl group, an n-propyl group, an i-propyl group, an n-butyl group, an i-butyl group, an s-butyl group, and a t-butyl group.

Specific examples of the cyclic alkyl group include a cyclopropyl group, a cyclobutyl group, a 1-methyl-cyclopropyl group, and a 2-methyl-cyclopropyl group, but are not limited thereto.

L⁵ is preferably a methyl group or an isopropyl group from the viewpoint of reproducibly realizing the releasing of the adhesive layer in a shorter time, the viewpoint of easy availability of the compound, and the like.

From the viewpoint of reproducibly realizing the releasing of the adhesive layer in a shorter time, from the viewpoint of easy availability of the compound, and the like, k is preferably 4 or less, more preferably 3 or less, and still more preferably 2 or less.

Preferable examples of the organic solvent represented by formula (L-2) include toluene, mesitylene, p-cymene, and 1,2,4-trimethylbenzene from the viewpoint of reproducibly realizing the releasing of the adhesive layer in a shorter time and the viewpoint of easy availability of the compound.

The content of the solvent represented by formula (L-2) in the releasing and dissolving composition is preferably 30 to 90 mass% and more preferably 40 to 80 mass% with respect to 100 mass% of aprotic solvents in the releasing and dissolving composition.

### <<<Component [II-3]: Solvent of aliphatic hydrocarbon compound>>>

The solvent of the aliphatic hydrocarbon compound is preferably a solvent represented by formulae (L-3-0) to (L-3-5) below.

The solvent represented by any one of formulae (L-3-0) to (L-3-5) below is effective as a release component for swelling the adhesive layer and releasing the adhesive layer from the semiconductor substrate.

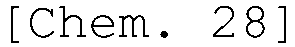

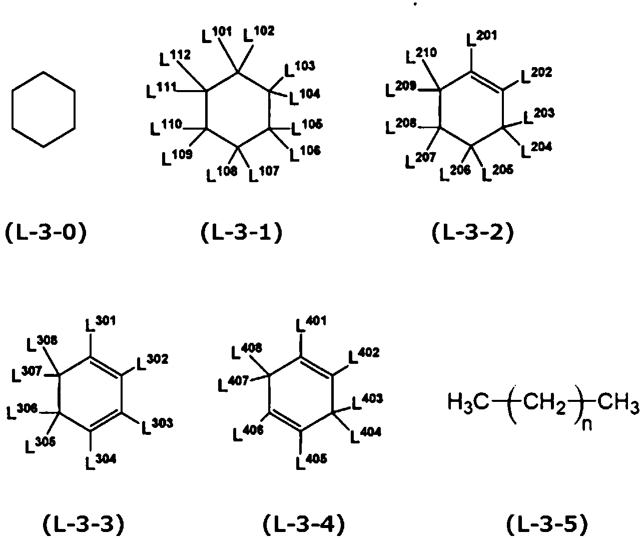

In formulae (L-3-0) to (L-3-5) above, L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, but at least one of L¹⁰¹ to L¹¹² represents an alkyl group having 1 to 5 carbon atoms, an alkenyl group having 2 to 5 carbon atoms, or an alkynyl group having 2 to 5 carbon atoms; L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, but at least one of L²⁰¹ to L²¹⁰ represents an alkyl group having 1 to 5 carbon atoms, an alkenyl group having 2 to 5 carbon atoms, or an alkynyl group having 2 to 5 carbon atoms; L³⁰¹ to L³⁰⁸ each independently represent a hydrogen atom, an alkyl group having 1 to 5 carbon atoms, an alkenyl group having 2 to 5 carbon atoms or an alkynyl group having 2 to 5 carbon atoms, but at least one of L³⁰¹ to L³⁰⁸ represents an alkyl group having 1 to 5 carbon atoms, an alkenyl group having 2 to 5 carbon atoms, or an alkynyl group having 2 to 5 carbon atoms; L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, but at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms; and n represents an integer of 9 or less.

The alkyl group may be a linear, branched, or cyclic alkyl group, but is preferably a linear or branched alkyl group.

Specific examples of the linear or branched alkyl group include, but are not limited to, a methyl group, an ethyl group, an n-propyl group, an i-propyl group, an n-butyl group, an i-butyl group, an s-butyl group, and a t-butyl group.

Among them, a methyl group, an ethyl group, an n-propyl group, or an isopropyl group is preferable, and a methyl group and an isopropyl group are more preferable, from the viewpoint of realizing releasing of the adhesive layer in a shorter time.

Specific examples of the cyclic alkyl group include, but are not limited to, a cyclopropyl group, a cyclobutyl group, a 1-methyl-cyclopropyl group, a 2-methyl-cyclopropyl group, and a cyclopentyl group.

The alkenyl group having 2 to 5 carbon atoms may be linear, branched, or cyclic, and specific examples thereof include, but are not limited to, an ethenyl group, an n-1-propenyl group, an n-2-propenyl group, a 1-methylethenyl group, an n-1-butenyl group, an n-2-butenyl group, an n-3-butenyl group, a 2-methyl-1-propenyl group, a 2-methyl-2-propenyl group, a 1-ethylethenyl group, a 1-methyl-1-propenyl group, a 1-methyl-2-propenyl group, and an n-1-pentenyl group.

Among them, an ethenyl group, a 1-ethylethenyl group, and a 2-methylethenyl group are preferable, and a 1-methylethenyl group is more preferable, from the viewpoint of reproducibly realizing releasing of the adhesive layer in a shorter time.

The alkynyl group having 2 to 5 carbon atoms may be linear, branched, or cyclic, and specific examples thereof include, but are not limited to, an ethynyl group, an n-1-propynyl group, an n-2-propynyl group, an n-1-butynyl group, an n-2-butynyl group, an n-3-butynyl group, a 1-methyl-2-propynyl group, an n-1-pentynyl group, an n-2-pentynyl group, an n-3-pentynyl group, an n-4-pentynyl group, a 1-methyl-n-butynyl group, a 2-methyl-n-butynyl group, a 3-methyl-n-butynyl group, and a 1,1-dimethyl-n-propynyl group.

Among them, an ethynyl group and a 2-methylethynyl group are preferable from the viewpoint of reproducibly realizing releasing of the adhesive layer in a shorter time.

From the viewpoint of reproducibly realizing releasing of the adhesive layer in a shorter time, preferably, one or two of L¹⁹¹ to L¹¹² are each independently an alkyl group having 1 to 5 carbon atoms, an alkenyl group having 2 to 5 carbon atoms, or an alkynyl group having 2 to 5 carbon atoms, and the remaining Ls are hydrogen atoms; more preferably, L¹⁹¹ is an alkyl group having 1 to 5 carbon atoms, an alkenyl group having 2 to 5 carbon atoms, or an alkynyl group having 2 to 5 carbon atoms, and the remaining Ls are hydrogen atoms; or L¹⁰¹ and L¹⁰⁷ are each independently an alkyl group having 1 to 5 carbon atoms, an alkenyl group having 2 to 5 carbon atoms, or an alkynyl group having 2 to 5 carbon atoms, and the remaining Ls are hydrogen atoms; and still more preferably, L¹⁰¹ is an alkyl group having 1 to 5 carbon atoms or an alkenyl group having 2 to 5 carbon atoms, and the remaining Ls are hydrogen atoms, or, L¹⁰¹ and L¹⁰⁷ are each independently an alkyl group having 1 to 5 carbon atoms or an alkenyl group having 2 to 5 carbon atoms, and the remaining Ls are hydrogen atoms.

From the viewpoint of reproducibly realizing releasing of the adhesive layer in a shorter time, preferably, one or two of L²⁰¹ to L²¹⁰ are each independently an alkyl group having 1 to 5 carbon atoms, an alkenyl group having 2 to 5 carbon atoms, or an alkynyl group having 2 to 5 carbon atoms, and the remaining Ls are hydrogen atoms; more preferably, L²⁰¹ is an alkyl group having 1 to 5 carbon atoms, an alkenyl group having 2 to 5 carbon atoms, or an alkynyl group having 2 to 5 carbon atoms, and the remaining Ls are hydrogen atoms; or L²⁰¹ and L²⁰⁵ are each independently an alkyl group having 1 to 5 carbon atoms, an alkenyl group having 2 to 5 carbon atoms, or an alkynyl group having 2 to 5 carbon atoms, and the remaining Ls are hydrogen atoms; and still more preferably, L²⁰¹ and L²⁰⁵ are each independently an alkyl group having 1 to 5 carbon atoms or an alkenyl group having 2 to 5 carbon atoms, and the remaining Ls are hydrogen atoms; yet still more preferably, L²⁰¹ is an alkyl group having 1 to 5 carbon atoms and L²⁰⁵ is an alkenyl group having 2 to 5 carbon atoms, and the remaining Ls are hydrogen atoms.

From the viewpoint of reproducibly realizing releasing of the adhesive layer in a shorter time, preferably, one or two of L³⁰¹ to L³⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms; more preferably, L³⁰¹ is an alkyl group having 1 to 5 carbon atoms, an alkenyl group having 2 to 5 carbon atoms, or an alkynyl group having 2 to 5 carbon atoms, and the remaining Ls are hydrogen atoms; or L³⁰¹ and L³⁰⁴ are each independently an alkyl group having 1 to 5 carbon atoms, an alkenyl group having 2 to 5 carbon atoms, or an alkynyl group having 2 to 5 carbon atoms, and the remaining Ls are hydrogen atoms; still more preferably, L³⁰¹ is an alkyl group having 1 to 5 carbon atoms or an alkenyl group having 2 to 5 carbon atoms, and the remaining Ls are hydrogen atoms, or, L³⁰¹ and L³⁰⁴ are each independently an alkyl group having 1 to 5 carbon atoms or an alkenyl group having 2 to 5 carbon atoms, and the remaining Ls are hydrogen atoms; yet still more preferably, L³⁰¹ is an alkyl group having 1 to 5 carbon atoms and the remaining Ls are hydrogen atoms, or L³⁰¹ and L³⁰¹ are each independently an alkyl group having 1 to 5 carbon atoms and the remaining Ls are hydrogen atoms.

From the viewpoint of reproducibly realizing releasing of the adhesive layer in a shorter time, preferably, one or two of L⁴⁰¹ to L⁴⁰⁸ are an alkyl group having 1 to 5 carbon atoms, an alkenyl group having 2 to 5 carbon atoms, or an alkynyl group having 2 to 5 carbon atoms, and the remaining Ls are hydrogen atoms; more preferably, L⁴⁰¹ is an alkyl group having 1 to 5 carbon atoms, an alkenyl group having 2 to 5 carbon atoms, or an alkynyl group having 2 to 5 carbon atoms, and the remaining Ls are hydrogen atoms; or L⁴⁰¹ and L⁴⁰⁵ are each independently an alkyl group having 1 to 5 carbon atoms, an alkenyl group having 2 to 5 carbon atoms, or an alkynyl group having 2 to 5 carbon atoms, and the remaining Ls are hydrogen atoms; still more preferably, L⁴⁰¹ is an alkyl group having 1 to 5 carbon atoms or an alkenyl group having 2 to 5 carbon atoms, and the remaining Ls are hydrogen atoms, or, L⁴⁰¹ and L⁴⁰⁵ are each independently an alkyl group having 1 to 5 carbon atoms or an alkenyl group having 2 to 5 carbon atoms, and the remaining Ls are hydrogen atoms; yet still more preferably, L⁴⁰¹ is an alkyl group having 1 to 5 carbon atoms and the remaining Ls are hydrogen atoms, or L⁴⁰¹ and L⁴⁰⁵ are each independently an alkyl group having 1 to 5 carbon atoms and the remaining Ls are hydrogen atoms.

Preferable examples of the organic solvent represented by formulae (L-3-0) to (L-3-5) include cyclohexane, p-menthane, isopropyl cyclohexane, limonene, n-decane, and the like from the viewpoint of reproducibly realizing the releasing of the adhesive layer in a shorter time and the viewpoint of ease of availability of the compound.

The content of the solvent represented by any one of formulae (L-3-0) to (L-3-5) (hereinafter, formulae (L-3-0) to (L-3-5) are also collectively referred to as formula (L-3) or the like) in the releasing and dissolving composition may be 20 mass% or more with respect to 100 mass% of aprotic solvents in the releasing and dissolving composition.

The content of the solvent represented by formula (L-3) or the like in the releasing and dissolving composition is preferably 20 mass% or more, more preferably 30 mass% or more, still more preferably 35 mass% or more, and preferably 80 mass% or less, more preferably 60 mass% or less with respect to 100 mass% of aprotic solvents in the releasing and dissolving composition. Any combination of these upper and lower limit values may be used.

### <<<Component [II-4]: Solvent of ester compound>>>

The solvent of the ester compound is preferably a solvent represented by formula (L-4) below.

The solvent represented by formula (L-4) below is effective as a release component for swelling the adhesive layer and releasing the adhesive layer from the semiconductor substrate.

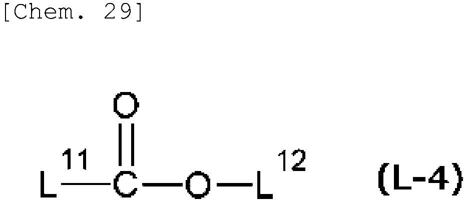

In formula (L-4), L¹¹ and L¹² each independently represent an alkyl group having 1 to 6 carbon atoms, and a total number of carbon atoms in the alkyl group of L¹¹ and the alkyl group of L¹² is 7 or less.

In formula (L-4), L¹¹ and L¹² each independently represent an alkyl group having 1 to 6 carbon atoms, and a total number of carbon atoms in the alkyl group of L¹¹ and the alkyl group of L¹² is 7 or less. By setting the number of carbon atoms as described above, release of the adhesive layer in a short time can be realized with good reproducibility.

The alkyl group may be linear, branched, or cyclic, but is preferably a linear or branched alkyl group, and more preferably a linear alkyl group.

Specific examples of the linear or branched alkyl group include, but are not limited to, a methyl group, an ethyl group, a n-propyl group, an i-propyl group, a n-butyl group, an i-butyl group, a s-butyl group, a t-butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl -1-methyl-n-propyl group, and a 1-ethyl-2-methyl-n-propyl group.

Specific examples of the cyclic alkyl group include, but are not limited to, cycloalkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group.

From the viewpoint of realizing release of the adhesive layer in a shorter time with good reproducibility, the L¹¹ is preferably a methyl group, and the L¹² is preferably a butyl group or a pentyl group.

Preferable examples of the organic solvent represented by formula (L-4) include butyl acetate and pentyl acetate from the viewpoint of realizing release of the adhesive layer in a shorter time with good reproducibility, the viewpoint of easy availability of the compound, and the like.

The content of the solvent represented by formula (L-4) in the releasing and dissolving composition can be set to more than 31 mass% with respect to 100 mass% of aprotic solvents in the releasing and dissolving composition.

The content of the solvent represented by formula (L-4) in the releasing and dissolving composition is preferably more than 31 mass%, more preferably more than 35 mass%, still more preferably 40 mass% or more, even more preferably 60 mass% or more, particularly preferably 70 mass% or more, and is preferably 90 mass% or less, and more preferably 80 mass% or less with respect to 100 mass% of aprotic solvents in the releasing and dissolving composition. Any combination of these upper and lower limit values may be used.

### <<Component [III]:>>

The component [III] refers to a solvent of glycol ethers.

The solvent of the glycol ethers is preferably a solvent represented by formula (T) below.

The solvent represented by formula (T) below is effective as an adjustment component for enhancing the compatibility between the amide-based solvent as the component [I-2] and the solvent of the component [II] in the releasing and dissolving composition containing the quaternary ammonium salt as the component [I-1].

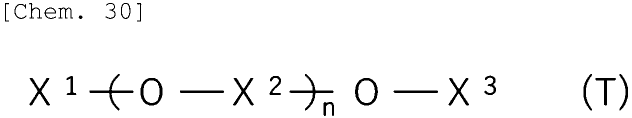

In formula (T), X¹ and X³ each independently represent an alkyl group or an acyl group (X⁴-C(=O)-), X² represents an alkylene group, n represents 2 or 3, and X⁴ represents an alkyl group.

Examples of the alkyl group represented by X₁ and X₃ include an alkyl group having 1 to 4 carbon atoms, and more specific examples thereof include a methyl group, an ethyl group, a propyl group, an isopropyl group, a n-butyl group, an isobutyl group, a sec-butyl group, and a t-butyl group.

Examples of the alkylene group represented by X₂ include a methylene group, a 1,2-ethylene group, a 1,3-propylene group, and a 1,2-propylene group.

Examples of the alkyl group represented by X₄ include an alkyl group having 1 to 4 carbon atoms, and examples thereof include the same alkyl groups as X₁ and X₃.

preferable examples of the solvent represented by formula (T) include dipropylene glycol dimethyl ether, diethylene glycol dimethyl ether, and diethylene glycol diethyl ether.

### <Contact angle>

For the releasing and dissolving composition, as described above, in a case where the releasing and dissolving composition is added dropwise onto an adhesive layer disposed on a semiconductor substrate to obtain the contact angle of the releasing and dissolving composition, the contact angle is more than 22.6 degrees and less than 46.1 degrees.

In the releasing and dissolving composition of the present invention containing the component [I] as the dissolution component and the component [II] as the release component, the contact angle of the releasing and dissolving composition when the releasing and dissolving composition is added dropwise onto the adhesive layer needs to be more than 22.6 degrees and less than 46.1 degrees.

When the contact angle is within the above range, since the dissolution function of the dissolution component and the release function of the release component are favorably exhibited, and the swelling, release, and dissolution of the adhesive layer are favorably performed together, the adhesive layer can be more cleanly removed (washed) from the semiconductor substrate in a shorter time.

From the viewpoint of reliably achieving swelling, release, and dissolution in a short time, the contact angle is preferably 24 degrees or more and 40 degrees or less, and more preferably 26 degrees or more and 38 degrees or less.

In the present invention, the adhesive layer that is removed by a method for cleaning a semiconductor substrate may be produced using any of an adhesive composition containing the release agent component (B) or an adhesive composition not containing the release agent component (B); however, from the viewpoint of achieving release in a shorter time with good reproducibility, it is desirable that the adhesive layer that is removed by the method for cleaning a semiconductor substrate of the present invention is produced from the adhesive composition containing the release agent component (B).

However, even in the case of using the adhesive composition containing the release agent component (B), an adhesive layer produced from an adhesive composition excluding the release agent component (B) is used as the adhesive layer when the contact angle of the releasing and dissolving composition is measured in the present invention.

In the present invention, a component that does not significantly affect the value of the contact angle at the time of measuring the contact angle of the releasing and dissolving composition is removed to increase the accuracy of the measurement in some cases.

In addition, as the releasing and dissolving composition, the releasing and dissolving composition from which the quaternary ammonium salt of the component [I-1] has been removed is used for measurement at the time of measuring the contact angle in the present invention to increase the accuracy of the measurement.

The contact angle can be measured using, for example, a fully automatic contact angle meter DM-701 manufactured by Kyowa Interface Science Co., Ltd.

### <<Release and dissolution step>>

In the present invention, the releasing and dissolving composition is continuously brought into contact with the adhesive layer on the semiconductor substrate. By performing this cleaning operation, swelling and release of the adhesive layer and dissolution of the adhesive layer are performed simultaneously. By performing swelling, release, and dissolution of the adhesive layer simultaneously by the cleaning operation using one cleaning composition, the adhesive layer can be removed (cleaned) from the semiconductor substrate more cleanly in a shorter time by a simple cleaning operation.

In the present invention, the removal (cleaning) means that the adhesive layer is removed from the semiconductor substrate, and both a case where the adhesive layer is swollen and released from the semiconductor substrate and a case where the adhesive layer is dissolved in a solution to disappear from the semiconductor substrate are included in the "removal (cleaning)".

The method for continuously bringing the adhesive layer on the semiconductor substrate into contact with the releasing and dissolving composition is not particularly limited as long as the adhesive layer on the semiconductor substrate is in contact with the releasing and dissolving composition with temporal continuity, and the temporal continuity includes not only a case where the adhesive layer is always in contact with the releasing and dissolving composition, but also, for example, a case where contact is made between the adhesive layer and the organic solvent for a certain period of time, and thereafter the contact is stopped once, and then the contact is made again, or this operation is repeated, and also includes not only a case where the entire adhesive layer on the semiconductor substrate is in contact with the releasing and dissolving composition, but also a case where a part of the adhesive layer is in contact with the releasing and dissolving composition, but from the viewpoint of realizing more effective cleaning with good reproducibility, an aspect in which the adhesive layer on the semiconductor substrate is always in contact with the releasing and dissolving composition is preferable, and an aspect in which the entire adhesive layer on the semiconductor substrate is in contact with the releasing and dissolving composition is preferable.

Therefore, in a preferable aspect of the present invention, the adhesive layer on the semiconductor substrate is swollen and dissolved by immersing the adhesive layer in the releasing and dissolving composition, and removed from the semiconductor substrate, or the adhesive layer on the semiconductor substrate is swollen and dissolved by continuously supplying the releasing and dissolving composition onto the adhesive layer and removed from the semiconductor substrate.

In order to immerse the adhesive layer on the semiconductor substrate in the releasing and dissolving composition, for example, the semiconductor substrate with the adhesive layer may be immersed in the releasing and dissolving composition.

The immersion time is defined as the time until swelling and dissolution of the adhesive layer occur and the adhesive layer is released from the semiconductor substrate, and is not particularly limited, but is 5 seconds or more from the viewpoint of realizing more effective cleaning with good reproducibility, and is 5 minutes or less from the viewpoint of throughput in the process.

When the adhesive layer on the semiconductor substrate is immersed in the releasing and dissolving composition, the removal (cleaning) of the adhesive layer may be promoted by moving the semiconductor substrate with the adhesive layer in the releasing and dissolving composition, causing convection of the releasing and dissolving composition, vibrating the releasing and dissolving composition by ultrasonic waves, or the like.

In order to move the semiconductor substrate with the adhesive layer in the releasing and dissolving composition, for example, a swing cleaner, a paddle type cleaner, or the like may be used. When such a cleaner is used, a table on which the semiconductor substrate with the adhesive layer is placed moves or rotates up and down or left and right, so that the adhesive layer on the semiconductor substrate relatively receives convection, or the adhesive layer on the semiconductor substrate receives convection generated by the movement or rotation, and not only swelling and dissolution of the adhesive layer on the semiconductor substrate but also release of the adhesive layer from the semiconductor substrate and dissolution are promoted.

In order to cause convection of the releasing and dissolving composition, for example, in a state where the semiconductor substrate with the adhesive layer is fixed to a stage or the like, a convection cleaner capable of realizing a state where the releasing and dissolving composition around the semiconductor substrate is circulated by convection with a stirrer may be typically used other than the swing cleaner and the paddle type cleaner described above.

In order to vibrate the releasing and dissolving composition by ultrasonic waves, an ultrasonic cleaner or an ultrasonic probe may be used, and the conditions thereof are usually 20 kHz to 5 MHz.

In order to continuously supply the releasing and dissolving composition onto the adhesive layer on the semiconductor substrate, the releasing and dissolving composition may be continuously applied to the adhesive layer on the semiconductor substrate. As an example, when the adhesive layer on the semiconductor substrate faces upward, for example, a rod-like or atomized, preferably rod-like releasing and dissolving composition is supplied with temporal continuity onto the adhesive layer on the semiconductor substrate from above (including obliquely above) the adhesive layer on the semiconductor substrate by a nozzle or the like of a cleaning apparatus. The temporal continuity in this case also includes not only a case where the releasing and dissolving composition is always supplied onto the adhesive layer on the semiconductor substrate, but also, for example, a case where supply of the releasing and dissolving composition is performed for a certain period of time, and thereafter the supply is stopped once, and then the supply is performed again, or this operation is repeated but from the viewpoint of realizing more effective cleaning with good reproducibility, it is preferable that the releasing and dissolving composition is always supplied onto the adhesive layer on the semiconductor substrate.

When the releasing and dissolving composition is supplied in a rod-like shape onto the adhesive layer on the semiconductor substrate, the flow rate is usually 200 to 500 mL/min.

In an aspect of the present invention, in order to realize a state of always being in contact with the releasing and dissolving composition, the adhesive layer on the semiconductor substrate may be brought into contact with the vapor of the releasing and dissolving composition using, for example, a steam cleaner.

When the method for producing a semiconductor of the present invention is used, as described above, by performing swelling, release, and dissolution of the adhesive layer simultaneously, the adhesive layer can be removed (cleaned) from the semiconductor substrate more cleanly in a shorter time by a simple cleaning operation. However, when the method for producing a semiconductor of the present invention is used, damage to a dicing tape in the cleaning step can be prevented.

For example, after a semiconductor wafer is polished and thinned, the semiconductor wafer after thinning is mounted on a dicing tape, and then the semiconductor wafer and the support are separated (released). After the support is separated (released), the adhesive layer remaining on the semiconductor wafer side is cleaned with the cleaning agent composition for removal from the semiconductor wafer. At that time, when a cleaning agent composition of a type that dissolves and removes an adhesive residue such as the cleaning agent compositions of Patent Literature 1 and 2 is used as the cleaning agent composition, the surface of the dicing tape changes, and the dicing tape is damaged.

However, when the semiconductor substrate with the adhesive layer is cleaned using the releasing and dissolving composition of the present invention, most of the adhesive layer can be released in a short time, and a small amount of the adhesive layer remaining after release is also dissolved by the dissolving component in the releasing and dissolving composition, so that the entire removal (cleaning) time for removing the adhesive layer is short, and the damage to the dicing tape in the cleaning step can be effectively prevented. In addition, the releasing and dissolving composition of the present invention contains not only a component for dissolving the adhesive layer but also a component for swelling and releasing the adhesive layer, and as a result, the proportion of the dissolving component, that is, the component [I-1] (quaternary ammonium salt) in the composition can be reduced, which also effectively contributes to preventing damage to the dicing tape.

When the step of removing the adhesive layer is performed using the releasing and dissolving composition of the present invention, damage to the dicing tape can be effectively prevented.

The method for producing a semiconductor substrate of the present invention may include a step of removing the released adhesive layer.

The method for removing the released adhesive layer is not particularly limited as long as the adhesive layer released from the semiconductor substrate is removed, and when the semiconductor substrate with the adhesive layer is immersed in the releasing and dissolving composition, the released adhesive layer present in the releasing and dissolving composition may be removed without taking out the semiconductor substrate from the releasing and dissolving composition. Alternatively, the semiconductor substrate may be taken out from the releasing and dissolving composition, and the released adhesive layer may be removed by separating the semiconductor substrate from the released adhesive layer. At this time, by simply taking out the semiconductor substrate from the releasing and dissolving composition, the released adhesive layer may naturally remain in the releasing and dissolving composition, and most of the adhesive layer can be removed in some cases.

Specific examples of the method for removing the released adhesive layer include, but are not limited to, methods for removing the released adhesive layer by adsorption or suction using an apparatus, removing the released adhesive layer by blowing off with a gas by an air gun or the like, and removing the released adhesive layer by a centrifugal force or the like caused by moving or rotating the semiconductor substrate up and down or left and right.

After the adhesive layer released from the semiconductor substrate is removed, if necessary, the semiconductor substrate is dried or the like according to a conventional method.

### (Releasing and dissolving composition)

The releasing and dissolving composition used in the method for producing a semiconductor substrate of the present invention is also an object of the present invention.

The releasing and dissolving composition of the present invention is used for removing (cleaning) an adhesive layer on a semiconductor substrate from the semiconductor substrate, and preferable aspects and conditions are as described above. The releasing and dissolving composition of the present invention can be produced by mixing a solvent constituting the composition in any order as necessary. At that time, if necessary, filtration or the like may be performed.

In the releasing and dissolving composition, the content ratio of the component [II], which contributes to swelling and releasing the adhesive layer, is relatively high. Therefore, when the releasing and dissolving composition of the present invention is brought into contact with the adhesive layer, the swelling and releasing of the adhesive layer and the dissolution of the adhesive layer are performed together.

For example, WO 2020/080060 A (hereinafter referred to as Publication P A) describes a method for cleaning an adhesive on a semiconductor substrate and a cleaning agent composition used in the production method. However, the adhesive described in Publication A is not a type of adhesive that can be swollen and released by a cleaning composition that is an object of the present invention. Therefore, in Publication A, there is originally no idea of swelling and releasing an adhesive layer as means for removing an adhesive, and the cleaning agent composition described in Publication A is only intended to remove an adhesive layer by dissolving the adhesive layer.

### (Method for Producing Processed Semiconductor Substrate)

When the method for producing a semiconductor substrate of the present invention described above is used, it is possible to efficiently remove an adhesive layer on a substrate of a semiconductor substrate, particularly an adhesive layer which is a cured film obtained from a siloxane-based adhesive containing a polyorganosiloxane component (A') that is cured by a hydrosilylation reaction, and it is possible to expect highly efficient and good production of a semiconductor element.

The method for producing a processed semiconductor substrate of the present invention is a method for producing a processed semiconductor substrate using the method for producing a semiconductor substrate of the present invention.

In the method for producing a processed semiconductor substrate of the present invention, for example, after a semiconductor wafer is polished and thinned, a support is separated (released) from the processed semiconductor wafer after thinning, and then an adhesive layer remaining on the semiconductor wafer side is removed (cleaned) using the method for producing a semiconductor substrate of the present invention, whereby a processed semiconductor substrate having a cleaned surface with no residual adhesive layer can be produced.

As described above, examples of use of the method for producing a semiconductor substrate of the present invention in a semiconductor process include use in a method for producing a processed semiconductor substrate such as thinning used in a semiconductor packaging technique such as TSV.

In addition to a silicon semiconductor substrate such as a silicon wafer described above, the semiconductor substrate to be cleaned by the production method of the present invention includes various substrates such as a germanium substrate, a gallium-arsenic substrate, a gallium-phosphorus substrate, a gallium-arsenic-aluminum substrate, an aluminum-plated silicon substrate, a copper-plated silicon substrate, a silver-plated silicon substrate, a gold-plated silicon substrate, a titanium-plated silicon substrate, a silicon nitride film-formed silicon substrate, a silicon oxide film-formed silicon substrate, a polyimide film-formed silicon substrate, a glass substrate, a quartz substrate, a liquid crystal substrate, and an organic EL substrate.

A preferable embodiment of the method for producing a processed semiconductor substrate of the present invention includes
a method for producing a processed semiconductor substrate, the method including:
a first step: a step of producing a laminate including a semiconductor substrate, a support substrate, and an adhesive layer obtained from an adhesive composition;
a second step: a step of processing the semiconductor substrate of the obtained laminate;
a third step: a step of separating the semiconductor substrate and the adhesive layer from the support substrate; and
a fourth step: a step of removing the adhesive layer on the semiconductor substrate by release and dissolution using a releasing and dissolving composition.

Here, the releasing and dissolving composition is as described in the section of <Releasing and dissolving composition> above.

In the fourth step, the method for producing a semiconductor substrate of the present invention is used.

Hereinafter, the respective steps will be described in detail.

### <First step>

As the adhesive composition used for forming the adhesive layer in the first step, the above-described various adhesives can be used, but the method for producing a semiconductor substrate of the present invention is effective in removing the adhesive layer obtained from a polysiloxane-based adhesive, and is more effective in removing the adhesive layer obtained from a polysiloxane-based adhesive containing the component (A) that is cured by a hydrosilylation reaction.

Therefore, an example in which when a processed semiconductor substrate is produced using the adhesive layer obtained using a polysiloxane-based adhesive (adhesive composition), the adhesive layer is removed by the production method of the present invention will be described below, but the present invention is not limited thereto.

A first step of producing a laminate including a semiconductor substrate, a support substrate, and an adhesive layer obtained from an adhesive composition will be described below.

In an aspect, the first step includes a step of coating a surface of a semiconductor substrate or a support substrate with an adhesive composition to form an adhesive coating layer, and a step of combining the semiconductor substrate and the support substrate with the adhesive coating layer interposed therebetween, bringing the semiconductor substrate and the support substrate into close contact with each other by applying a load in a thickness direction of the semiconductor substrate and the support substrate while performing at least one of a heating treatment and a decompression treatment, and then performing a post-heating treatment to form a laminate.

In another aspect, the first step includes, for example, a step of coating a circuit surface of a wafer of a semiconductor substrate with an adhesive composition and heating the adhesive composition to form an adhesive coating layer, a step of coating a surface of a support substrate with a release agent composition and heating the release agent composition to form a release agent coating layer, and a step of bringing the adhesive coating layer of the semiconductor substrate and the release agent coating layer of the support substrate into close contact with each other by applying a load in a thickness direction of the semiconductor substrate and the support substrate while performing at least one of a heating treatment and a decompression treatment, and then performing a post-heating treatment to form a laminate. Although the adhesive composition and the release agent composition are applied to the semiconductor substrate and the support substrate, respectively, and heated, the application and heating of the adhesive composition and the release agent composition may be sequentially performed on either one of the substrates.

In each of the above aspects, which treatment condition of the heating treatment, the decompression treatment, or both in combination, is adopted is appropriately determined in consideration of various circumstances such as the type of the adhesive composition, the specific formulation of the release agent composition, the compatibility of the films obtained from both compositions, the film thickness, and the required adhesive strength.

Here, for example, the semiconductor substrate is a wafer, and the support substrate is a support. The object to be coated with the adhesive composition may be either one or both of the semiconductor substrate and the support substrate.

Examples of the wafer include, but are not limited to, a silicon wafer and a glass wafer having a diameter of about 300 mm and a thickness of about 770 µm.

In particular, the method for producing a semiconductor substrate of the present invention enables effective cleaning of a substrate also for a semiconductor substrate with bumps.

Specific examples of such a semiconductor substrate with bumps include a silicon wafer with bumps such as ball bumps, printed bumps, stud bumps, or plated bumps, and usually, the semiconductor substrate with bumps is appropriately selected from the conditions of a bump height of about 1 to 200 µm, a bump diameter of 1 to 200 µm, and a bump pitch of 1 to 500 µm.

Specific examples of the plated bumps include, but are not limited to, Sn-based alloy plating such as SnAg bumps, SnBi bumps, Sn bumps, and AuSn bumps.

The support (carrier) is not particularly limited, and examples thereof include, but are not limited to, a silicon wafer having a diameter of about 300 mm and a thickness of about 700 µm.

Examples of the release agent composition include a composition containing a release agent component used for this type of application.

The application method is not particularly limited, and is ordinarily a spin coating method. A method for separately forming a coating film by a spin coating method or the like and bonding the coating film in a sheet-like form may be adopted, which is also referred to as coating or a coating film.

The heating temperature of the applied adhesive composition varies depending on the type and amount of the adhesive component contained in the adhesive composition, whether or not a solvent is contained, the desired thickness of the adhesive layer, and the like, and thus cannot be unconditionally defined, but is usually 80°C to 150°C, and the heating time is usually 30 seconds to 5 minutes.

The heating temperature of the applied release agent composition varies depending on the type and amount of the crosslinking agent, the acid generator, the acid, and the like, whether or not a solvent is contained, the desired thickness of the release layer, and the like, and thus cannot be unconditionally defined, but is 120°C or higher from the viewpoint of realizing suitable curing, and is preferably 260°C or lower from the viewpoint of preventing excessive curing, and the heating time is usually 1 to 10 minutes.

The heating can be performed using a hot plate, an oven, or the like.

The film thickness of the adhesive coating layer obtained by applying the adhesive composition and heating the adhesive composition is usually 5 to 500 µm.

The film thickness of the release agent coating layer obtained by applying the release agent composition and heating the release agent composition is usually 5 to 500 µm.

The heating treatment is usually appropriately determined from the range of 20°C to 150°C from the viewpoint of softening the adhesive coating layer to realize suitable bonding with the release agent coating layer, the viewpoint of realizing suitable curing of the release agent coating layer, and the like. In particular, from the viewpoint of preventing or avoiding excessive curing or unnecessary alteration of the adhesive component or the release agent component, the heating temperature is preferably 130°C or lower, more preferably 90°C or lower, and the heating time is usually 30 seconds or more, and preferably 1 minute or more from the viewpoint of reliably exhibiting an adhesive ability and a releasing ability, and is usually 10 minutes or less, and preferably 5 minutes or less from the viewpoint of preventing alteration of the adhesive layer or other members.

In the decompression treatment, the semiconductor substrate, the adhesive coating layer, and the support substrate, or the semiconductor substrate, the adhesive coating layer, the release agent coating layer, and the support substrate may be exposed to an air pressure of 10 to 10,000 Pa. The time for the decompression treatment is usually 1 to 30 minutes.

In a preferable aspect of the present invention, the substrate and the coating layer or the coating layers are bonded to each other preferably by a decompression treatment, more preferably by a combination of a heating treatment and a decompression treatment.

The load in the thickness direction of the semiconductor substrate and the support substrate is not particularly limited as long as the load does not adversely affect the semiconductor substrate, the support substrate, and the layers therebetween, and can bring these into close contact with one another, and is usually in the range of 10 to 1,000 N.

The post-heating temperature is preferably 120°C or higher from the viewpoint of obtaining a sufficient curing rate, and is preferably 260°C or lower from the viewpoint of preventing alteration of the substrate, the adhesive component, the release agent component, and the like. The heating time is usually 1 minute or more from the viewpoint of realizing suitable bonding of wafers by curing, and is preferably 5 minutes or more from the viewpoint of stabilizing the physical properties of the adhesive, and the like, and is usually 180 minutes or less, and preferably 120 minutes or less from the viewpoint of avoiding, for example, an adverse effect on the adhesive layer due to excessive heating. The heating can be performed using a hot plate, an oven, or the like.

One object of the post-heating treatment is to more suitably cure the adhesive component (S).

### <Second step>

Next, the second step of processing the semiconductor substrate of the laminate obtained by the method described above will be described.

Examples of the processing applied to the laminate used in the present invention include processing of the back surface opposite to the circuit surface of the front surface of the semiconductor substrate, and typically include thinning of a wafer by polishing the back surface of the wafer. A through silicon via (TSV) or the like is formed using such a thinned wafer, and then the thinned wafer is released from the support to form a laminate of wafers, which is three-dimensionally mounted. Before and after that, a wafer back electrode or the like is also formed. Heat at 250°C to 350°C is applied for the thinning of the wafer and the TSV process in a state of being adhered to the support, and the adhesive layer included in the laminate used in the present invention has heat resistance to the heat.

For example, a wafer having a diameter of about 300 mm and a thickness of about 770 µm can be thinned to a thickness of about 80 to 4 µm by polishing the back surface opposite to the circuit surface of the front surface.

### <Third step>

The third step of separating the processed semiconductor substrate and the adhesive layer from the support substrate will be described.

In the third step, the processed semiconductor substrate and the adhesive layer are separated from the support substrate. At this time, when the release layer is included in the laminate, usually, the release layer is also removed together with the support substrate.

In a method for separating the processed semiconductor substrate and the adhesive layer from the semiconductor substrate, it is only necessary to release the adhesive layer from the release layer or the support substrate in contact with the adhesive layer, and examples of such a releasing method include, but are not limited to, laser releasing, mechanical releasing with machinery having a sharp portion, and manual releasing.

### <Fourth step>

Next, the fourth step of removing the adhesive layer on the processed semiconductor substrate and cleaning the processed semiconductor substrate will be described.

The fourth step is a step of removing the adhesive layer on the semiconductor substrate by the method for producing a semiconductor substrate of the present invention (corresponding to the cleaning step in the method for producing a semiconductor substrate of the present invention), and specifically, for example, the adhesive layer on the thinned substrate is cleanly removed in a short time by the production method of the present invention. Various conditions at this time are as described above.

As described above, swelling and dissolution act simultaneously on the adhesive layer only by performing a cleaning operation using the releasing and dissolving composition of the present invention, and thus, in the fourth step, the adhesive layer on the semiconductor substrate can be removed more cleanly in a short time.

The method for producing a processed semiconductor substrate of the present invention includes the first step to the fourth step described above, but may include steps other than these steps. The constituent elements and method elements related to the first step to the fourth step may be variously changed without departing from the gist of the present invention.

### Examples

Hereinafter, the contents and effects of the present invention will be described in more detail by way of examples, but the present invention is not limited thereto. The apparatus used is as follows.

### [Apparatus]

(1) Stirrer A: rotation and revolution mixer ARE-500, manufactured by THINKY CORPORATION
(2) Stirrer B: mixing rotor VMR-5R, manufactured by AS ONE Corporation
(3) Viscometer: rotational viscometer TV-35H manufactured by Toki Sangyo Co., Ltd.
(4) Optical microscope: semiconductor/FPD inspection microscope MX61L, manufactured by Olympus Corporation
(5) Contact angle meter: Fully automatic contact angle meter DM-702 manufactured by Kyowa Interface Science Co., Ltd.

### [1] Preparation of adhesive composition 1

### [Example 1-1]

In a 600 mL stirring vessel dedicated to a stirrer A, 62.10 g of a vinyl group-containing linear polydimethylsiloxane having a viscosity of 200 mPa·s and represented by the following formula (V), and 82.25 g of a base polymer made of a vinyl group-containing MQ resin (manufactured by Wacker Chemie AG), as the component (a1), 15.23 g of an SiH group-containing linear polydimethylsiloxane having a viscosity of 100 mPa·s (manufactured by Wacker Chemie AG) as the component (a2), and 0.42 g of 1-ethynyl-1-cyclohexanol (manufactured by Wacker Chemie AG) as the component (A3) were charged and stirred with the stirrer A for 5 minutes to obtain a mixture (I).

In a 50 mL screw tube, 0.24 g of a platinum catalyst (manufactured by Wacker Chemie AG) as the component (A2) and 10.07 g of a vinyl group-containing linear polydimethylsiloxane having a viscosity of 1000 mPa·s and represented by formula (W) below (manufactured by Wacker Chemie AG) as the component (a1) were stirred for 5 minutes with the stirrer A to obtain a mixture (II).

To the mixture (I), 7.14 g of the obtained mixture (II) was added, and the mixture was stirred with the stirrer A for 5 minutes to obtain a mixture (III).

The finally obtained mixture (III) was filtered through a nylon filter 300 mesh to obtain an adhesive composition. The viscosity of the adhesive composition measured using the rotational viscometer was 9900 mPa·s.

### [Example 1-2]

In a 600 mL stirring container dedicated to the stirrer A, 99.12 g of a p-menthane solution (concentration: 80.6 mass%) of an MQ resin (manufactured by Wacker Chemie AG) having a polysiloxane skeleton and a vinyl group as the component (a1), 22.12 g of a polyorganosiloxane represented by formula (M1) as the component (B) (complex viscosity: 6,000 Pa·s, weight average molecular weight: 642,000 (dispersity: 2.6), manufactured by Wacker Chemie AG, trade name: GENIOPLAST GUM), 48.89 g of p-menthane (manufactured by Nippon Terpene Chemicals, Inc.), and 5.43 g of n-decane (manufactured by SANKYO CHEMICAL CO., LTD.) were added, and stirring with the stirrer A for 5 minutes was repeated a total of 8 times with a short break in between to obtain a mixture (I) (total stirring time: 40 minutes).

To the obtained mixture (I), 15.98 g of SiH group-containing linear polydimethylsiloxane (manufactured by Wacker Chemie AG) having a viscosity of 100 mPa·s as the component (a2) and 23.35 g of vinyl group-containing linear polydimethylsiloxane (manufactured by Wacker Chemie AG) having a viscosity of 200 mPa·s as the component (a1) were added to obtain a mixture (II).

As the component (A3), 0.31 g of 1,1-diphenyl-2-propyn-1-ol (manufactured by Tokyo Chemical Industry Co., Ltd.), as the component (A3), 0.31 g of 1-ethynyl-1-cyclohexanol (manufactured by Wacker Chemie AG), and 0.61 g of p-menthane (manufactured by Nippon Terpene Chemicals, Inc.) were stirred with the stirrer B for 60 minutes to obtain a mixture (III).

To the mixture (II), 1.23 g of the obtained mixture (III) was added, and the mixture was stirred with the stirrer A for 5 minutes to obtain a mixture (IV).

As the component (A2), 0.074 g of a platinum catalyst (manufactured by Wacker Chemie AG) and as the component (a1), 7.37 g of a vinyl group-containing linear polydimethylsiloxane (manufactured by Wacker Chemie AG) having a viscosity of 1,000 mPa·s were stirred with the stirrer A for 5 minutes to obtain a mixture (V).

To the mixture (IV), 3.72 g of the obtained mixture (V) was added, and the mixture was stirred with the stirrer A for 5 minutes to obtain a mixture (VI).

Finally, the obtained mixture (VI) was filtered through a 300-mesh nylon filter to obtain an adhesive composition. In addition, the viscosity of the obtained adhesive composition was 2,700 mPa·s.

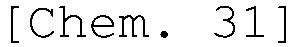

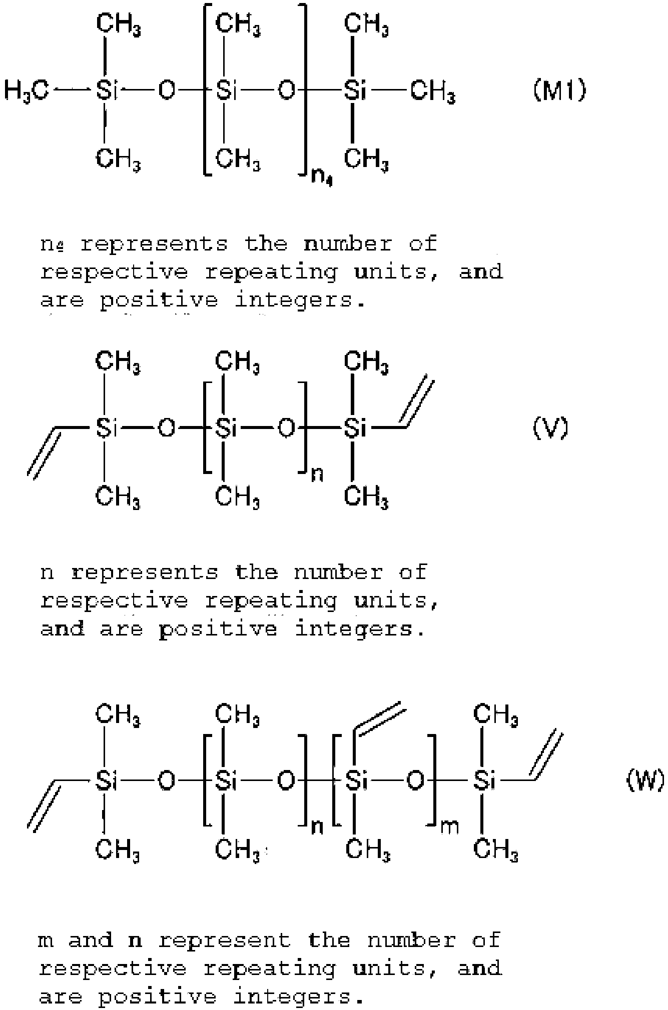

### [2] Preparation of cleaning composition

### [Example 2-1]

To 0.36 g of tetrabutylammonium fluoride trihydrate (manufactured by KANTO CHEMICAL CO., INC.), 3.7 g of N-methyl-2-pyrrolidone, 5.5 g of dibutyl ether, and 2.8 g of dipropylene glycol dimethyl ether were added, followed by stirring to obtain a cleaning composition.

### [Example 2-2] to [Example 2-5], [Comparative Example 1-1] to [Comparative Example 1-3]

Cleaning compositions were obtained in the same manner as in Example 2-1 except that adjustment was made to provide the formulations in Table 1.

### [Example 2-6] and [Example 2-7]

Cleaning compositions were obtained in the same manner as in Example 2-1 except that N-ethyl-2-pyrrolidone was used in place of N-methyl-2-pyrrolidone as the N-substituted amide compound and adjustment was made to provide the formulations in Table 1.

### [Example 2-8]

4.8 g of N-methyl-2-pyrrolidone, 4.8 g of dibutyl ether, and 2.4 g of butyl acetate were added to 0.36 g of tetrabutylammonium fluoride trihydrate (manufactured by KANTO CHEMICAL CO., INC.) and stirred to obtain a cleaning composition.

### [Example 2-9]

1.2 g of N-methyl-2-pyrrolidone, 8.4 g of butyl acetate, and 2.4 g of dipropylene glycol dimethyl ether were added to 0.36 g of tetrabutylammonium fluoride trihydrate (manufactured by KANTO CHEMICAL CO., INC.) and stirred to obtain a cleaning composition.

### [Example 2-10]

1.2 g of N-methyl-2-pyrrolidone and 10.8 g of butyl acetate were added to 0.36 g of tetrabutylammonium fluoride trihydrate (manufactured by KANTO CHEMICAL CO., INC.) and stirred to obtain a cleaning composition.

### [Example 2-11]

3.6 g of N-methyl-2-pyrrolidone and 8.4 g of mesitylene were added to 0.36 g of tetrabutylammonium fluoride trihydrate (manufactured by KANTO CHEMICAL CO., INC.) and stirred to obtain a cleaning composition.

### [Example 2-12]

3.6 g of N-methyl-2-pyrrolidone, 3.6 g of P-menthane, and 4.8 g of dipropylene glycol dimethyl ether were added to 0.36 g of tetrabutylammonium fluoride trihydrate (manufactured by KANTO CHEMICAL CO., INC.) and stirred to obtain a cleaning composition.

### [Example 2-13]

4.8 g of N-methyl-2-pyrrolidone, 4.8 g of P-menthane, and 2.4 g of dipropylene glycol dimethyl ether were added to 0.36 g of tetrabutylammonium fluoride trihydrate (manufactured by KANTO CHEMICAL CO., INC.) and stirred to obtain a cleaning composition.

### [Comparative Example 1-4]

12.0 g of N-methyl-2-pyrrolidone was added to 0.36 g of tetrabutylammonium fluoride trihydrate (manufactured by KANTO CHEMICAL CO., INC.) and stirred to obtain a cleaning composition.

### [Comparative Example 1-5]

12.0 g of dibutyl ether was added to 0.36 g of tetrabutylammonium fluoride trihydrate (manufactured by KANTO CHEMICAL CO., INC.) and stirred to obtain a cleaning composition.

### [3] Preparation of substrate for evaluation

### [Production Example 1]

The adhesive composition obtained in Example 1-1 was applied by spin coating to a 4 cm × 4 cm silicon wafer (thickness: 775 µm) as a device-side wafer, and heated at 200°C for 10 minutes to form a thin film having a thickness of about 65 µm on the wafer, thereby obtaining a wafer with an adhesive layer.

### [Production Example 2]

The adhesive composition obtained in Example 1-2 was applied by spin coating to a 4 cm × 4 cm silicon wafer (thickness: 775 µm) as a device-side wafer, and heated at 110°C for 1.5 minutes, and then heated at 200°C for 10 minutes to form a thin film having a thickness of about 40 µm on the wafer, thereby obtaining a wafer with an adhesive layer.

### [4] Measurement of contact angle

Each solution prepared in [Example 2-1] to [Example 2-13] and [Comparative Example 1-1] to [Comparative Example 1-5] was added dropwise onto the adhesive layer of the wafer with an adhesive layer prepared in Production Example 1, and the contact angle of each solution was measured. In [Example 2-1] to [Example 2-13] and [Comparative Example 1-1] to [Comparative Example 1-5] for contact angle measurement, the measurement was performed without adding tetrabutylammonium fluoride trihydrate to prevent the adhesive from dissolving at the same time as the dropwise addition of the solution and to increase the accuracy of the measurement. Table 1 shows the results.

### [5] Measurement of release time

The wafer with an adhesive layer prepared in Production Example 2 was immersed in 7 mL of each of the cleaning compositions obtained in the examples and the comparative examples. The time until the adhesive layer was completely released from the wafer was defined as the release time. Table 1 shows the results.

### [6] Observation of presence or absence of residue after release

The wafer with an adhesive layer prepared in Production Example 2 was immersed in 7 mL of each of the cleaning compositions obtained in [Example 2-1] to [Example 2-13] and [Comparative Example 1-1] to [Comparative Example 1-5]. When the adhesive layer was released within 1 minute after immersion in the cleaning composition, the released adhesive layer was removed with forceps. The substrate was left for 1 minute from the start of immersion, and then cleaned with isopropanol and ultrapure water, and the presence or absence of a residue on the substrate was observed with an optical microscope. The results are shown in Table 1 below. In [Comparative Example 1-1] to [Comparative Example 1-4], the adhesive layer was not released even after 300 seconds in the test of [5], and therefore the test of [6] was not performed (indicated by "N.A." in the table).

It has been found from the results of Table 1 that when the semiconductor substrate with an adhesive layer is cleaned using the releasing and dissolving composition of the present invention, the adhesive layer can be removed (cleaned) from the semiconductor substrate in a short time as shown in Examples 2-1 to 2-13. In the present invention, most of the adhesive layer can be released in a short time, even if a small amount of the adhesive layer remains after release, the adhesive residue is dissolved by the dissolving component in the releasing and dissolving composition, and is cleanly removed. This is also shown by the results of Examples 2-1 to 2-13. As shown in Examples 2-1 to 2-13, the adhesive layer on the semiconductor substrate could be cleanly eliminated only by immersing the semiconductor substrate in the releasing and dissolving composition of the present invention for a short time of one minute. In addition, it was confirmed from the results of the contact angle measurement that when the contact angle of the releasing and dissolving composition on the adhesive layer is more than 22.6° and less than 46.1°, release and dissolution of the adhesive on the substrate can be achieved at the same time.

That is, when the method for cleaning a semiconductor substrate of the present invention is used, it is possible to remove (clean) the adhesive layer from the semiconductor substrate having the adhesive layer on the surface thereof more cleanly in a shorter time by a simple operation.

**[Table 1]**

| | Composition | | | | | | | | Contact angle | Release time (sec) | Residue after release |
|---|---|---|---|---|---|---|---|---|---|---|---|
| | N-substituted amide compound (g) | | Lift-off solvent (g) | | | | Additive (g) | TBAF (phr relative to total amount of solvent) | | | |
| | N-methyl-2-pyrrolidone | N-ethyl-2-pyrrolidone | Dibutyl ether | Butyl acetate | Mesitylene | p-menthane | Dipropylene glycol dimethyl ether | | | | |
| Example 2-1 | 3.7 | | 5.5 | | | | 2.8 | | 33 | 18 | None |
| Example 2-2 | 3.7 | | 7.7 | | | | 0.6 | | 24 | 13 | None |
| Example 2-3 | 3.6 | | 3.6 | | | | 4.8 | | 36.9 | 29 | None |
| Example 2-4 | 4.8 | | 3.6 | | | | 3.6 | 3 | 38.3 | 44 | None |
| Example 2-5 | 7.2 | | 4.8 | | | | | | 32 | 29 | None |
| Example 2-6 | | 3.7 | 5.5 | | | | 2.8 | | 32.3 | 17 | None |
| Example 2-7 | | 4.8 | 4.8 | | | | 2.4 | 5 | 36.3 | 19 | None |
| Example 2-8 | 4.8 | | 4.8 | 2.4 | | | | | 37.4 | 19 | None |
| Example 2-9 | 1.2 | | | 8.4 | | | 2.4 | | 34.2 | 21 | None |
| Example 2-10 | 1.2 | | | 10.8 | | | | | 32.1 | 15 | None |
| Example 2-11 | 3.6 | | | | 8.4 | | | | 40.5 | 58 | None |
| Example 2-12 | 3.6 | | | | | 3.6 | 4.8 | | 38.3 | 18 | None |
| Example 2-13 | 4.8 | | | | | 4.8 | 2.4 | | 29.6 | 15 | None |
| Comparative Example 1-1 | 8.4 | | 1.2 | | | | 2.4 | 3 | 46.8 | 300 < | N.A. |
| Comparative Example 1-2 | 6.0 | | 1.2 | | | | 4.8 | | 46.5 | 300 < | N.A. |
| Comparative Example 1-3 | 3.6 | | 1.2 | | | | 7.2 | | 46.1 | 300 < | N.A. |
| Comparative Example 1-4 | 12.0 | | | | | | | | 65.5 | 300 < | N.A. |
| Comparative Example 1-5 | | | 12.0 | | | | | | 22.6 | 8 | TBAF insoluble |

## Claims

1. A method for producing a semiconductor substrate, comprising:
a step of releasing and dissolving an adhesive layer on a semiconductor substrate using a releasing and dissolving composition, and cleaning the adhesive layer,
wherein the releasing and dissolving composition contains:
a component [I]: a dissolution component containing a quaternary ammonium salt and an amide-based solvent, and
a component [II]: a release component having a molecular weight of less than 160 and being composed of one or more solvents selected from an ether compound, a thioether compound, an aromatic hydrocarbon compound, an aliphatic hydrocarbon compound, an ester compound, and an amine compound, and
a contact angle of the releasing and dissolving composition when the releasing and dissolving composition is added dropwise onto the adhesive layer disposed on the semiconductor substrate is more than 22.6 degrees and less than 46.1 degrees.

2. The method for producing a semiconductor substrate according to claim 1, wherein the solvent of the ether compound or the thioether compound as the component [II] is a solvent represented by formula (L-1) below:
[Chem. 1] **L¹-L³-L² (L-1)**
in the formula, L¹ and L² each independently represent an alkyl group having 2 to 5 carbon atoms, and L³ represents O or S.

3. The method for producing a semiconductor substrate according to claim 1, wherein the solvent of the aromatic hydrocarbon compound as the component [II] is a solvent represented by formula (L-2) below: 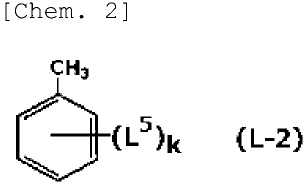 in the formula, L⁵'s represent a substituent substituted with a benzene ring and each independently represent an alkyl group having 1 to 4 carbon atoms, and k represents a number of L⁵ and is an integer of 0 to 5.

4. The method for producing a semiconductor substrate according to claim 1, wherein the solvent of the aliphatic hydrocarbon compound as the component [II] is a solvent represented by formulae (L-3-0) to (L-3-5) below: 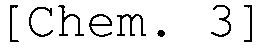 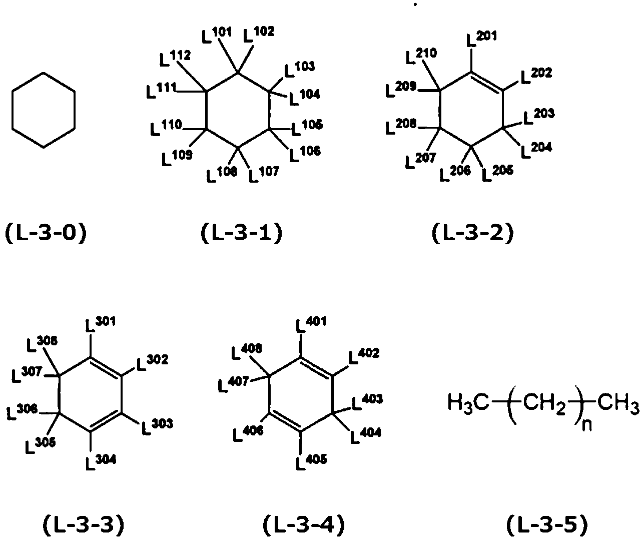 in the formulae, L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, but at least one of L¹⁰¹ to L¹¹² represents an alkyl group having 1 to 5 carbon atoms, an alkenyl group having 2 to 5 carbon atoms, or an alkynyl group having 2 to 5 carbon atoms; L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, but at least one of L²⁰¹ to L²¹⁰ represents an alkyl group having 1 to 5 carbon atoms, an alkenyl group having 2 to 5 carbon atoms, or an alkynyl group having 2 to 5 carbon atoms; L³⁰¹ to L³⁰⁸ each independently represent a hydrogen atom, an alkyl group having 1 to 5 carbon atoms, an alkenyl group having 2 to 5 carbon atoms or an alkynyl group having 2 to 5 carbon atoms, but at least one of L³⁰¹ to L³⁰⁸ represents an alkyl group having 1 to 5 carbon atoms, an alkenyl group having 2 to 5 carbon atoms, or an alkynyl group having 2 to 5 carbon atoms; L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, but at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms; and n represents an integer of 9 or less.

5. The method for producing a semiconductor substrate according to claim 1, wherein the solvent of the ester compound as the component [II] is a solvent represented by formula (L-4) below: 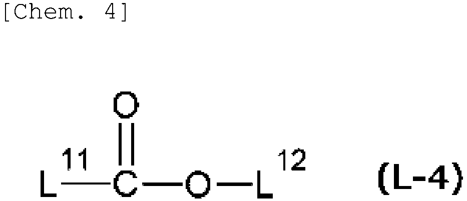 in the formula, L¹¹ and L¹² each independently represent an alkyl group having 1 to 6 carbon atoms, and a total of a number of carbon atoms in the alkyl group as L¹¹ and a number of carbon atoms in the alkyl group as L¹² is 7 or less.

6. The method for producing a semiconductor substrate according to claim 1, wherein the releasing and dissolving composition further contains a component [III]: a solvent of glycol ethers.

7. The method for producing a semiconductor substrate according to claim 6, wherein the solvent of the glycol ethers as the component [III] is a solvent represented by formula (T) below: 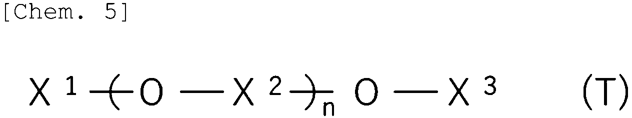 in the formula, X¹ and X³ each independently represent an alkyl group or an acyl group (X⁴-C(=O)-), X² represents an alkylene group, n represents 2 or 3. X⁴ represents an alkyl group.

8. The method for producing a semiconductor substrate according to claim 1, wherein the quaternary ammonium salt as the component [I] is a halogen-containing quaternary ammonium salt.

9. The method for producing a semiconductor substrate according to claim 1, wherein the amide-based solvent as the component [I] is an acid amide derivative represented by formula (Z) below or a compound represented by formula (Y) below: 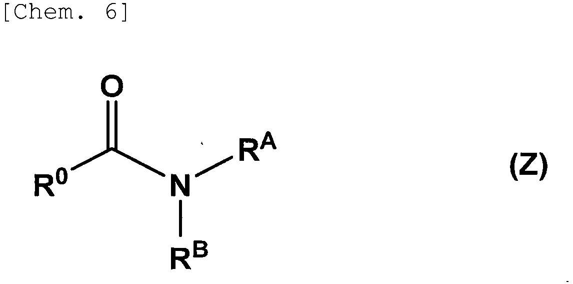
in the formula, R⁰ represents an ethyl group, a propyl group, or an isopropyl group, and R^{A} and R^{B} each independently represent an alkyl group having 1 to 4 carbon atoms, 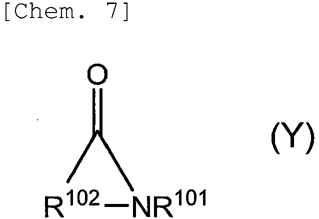
in the formula, R¹⁰¹ represents a hydrogen atom or an alkyl group having 1 to 6 carbon atoms, and R¹⁰² represents an alkylene group having 1 to 6 carbon atoms or a group represented by formula (Y1) below, and 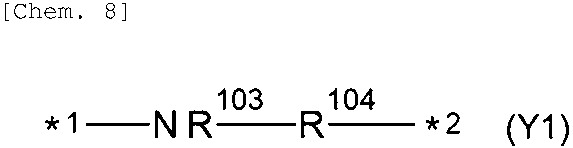
in the formula, R¹⁰³ represents a hydrogen atom or an alkyl group having 1 to 6 carbon atoms, R¹⁰⁴ represents an alkylene group having 1 to 5 carbon atoms, *1 represents a bonding hand bonded to a carbon atom in formula (Y), and *2 represents a bonding hand bonded to a nitrogen atom in formula (Y).

10. The method for producing a semiconductor substrate according to claim 1, wherein the adhesive layer is a film obtained using an adhesive composition containing an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenol resin-based adhesive.

11. The method for producing a semiconductor substrate according to claim 10, wherein the adhesive component (S) contains a siloxane-based adhesive.

12. The method for producing a semiconductor substrate according to claim 11, wherein the siloxane-based adhesive contains a polyorganosiloxane component (A') that is cured by a hydrosilylation reaction.

13. The method for producing a semiconductor substrate according to claim 1, wherein the release and dissolution step includes a step of removing the released adhesive layer.

14. A method for producing a processed semiconductor substrate, the processed semiconductor substrate being produced using the method for producing a semiconductor substrate according to claim 1, the method comprising:
a first step of producing a laminate including a semiconductor substrate, a support substrate, and an adhesive layer obtained from an adhesive composition;
a second step of processing the semiconductor substrate of the obtained laminate;
a third step of separating the semiconductor substrate and the adhesive layer from the support substrate; and
a fourth step that is the cleaning step defined in claim 1 of removing the adhesive layer on the semiconductor substrate by release and dissolution using the releasing and dissolving composition.

15. A releasing and dissolving composition that is used to remove an adhesive layer on a semiconductor substrate by release and dissolution at a time of cleaning the semiconductor substrate,
wherein the releasing and dissolving composition contains:
a component [I]: a dissolution component containing a quaternary ammonium salt and an amide-based solvent, and
a component [II]: a release component having a molecular weight of less than 160 and being composed of one or more solvents selected from an ether compound, a thioether compound, an aromatic hydrocarbon compound, an aliphatic hydrocarbon compound, an ester compound, and an amine compound, and
a contact angle of the releasing and dissolving composition when the releasing and dissolving composition is added dropwise onto the adhesive layer disposed on the semiconductor substrate is more than 22.6 degrees and less than 46.1 degrees.

16. The releasing and dissolving composition according to claim 15, wherein the solvent of the ether compound or the thioether compound as the component [II] is a solvent represented by formula (L-1) below:
[Chem. 9] **L¹-L³-L² (L-1)**
in the formula, L¹ and L² each independently represent an alkyl group having 2 to 5 carbon atoms, and L³ represents O or S.

17. The releasing and dissolving composition according to claim 15, wherein the solvent of the aromatic hydrocarbon compound as the component [II] is a solvent represented by formula (L-2) below: 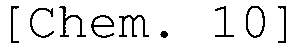 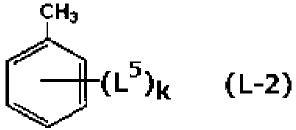 in the formula, L⁵'s represent a substituent substituted with a benzene ring and each independently represent an alkyl group having 1 to 4 carbon atoms, and k represents a number of L⁵ and is an integer of 0 to 5.

18. The releasing and dissolving composition according to claim 15, wherein the solvent of the aliphatic hydrocarbon compound as the component [II] is a solvent represented by formulae (L-3-0) to (L-3-5) below: 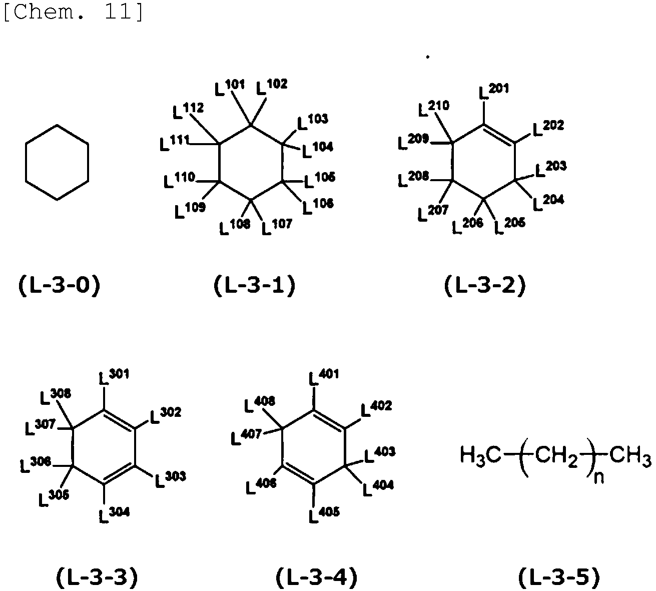 in the formulae, L¹⁰¹ to L¹¹² each independently represent a hydrogen atom, an alkyl group having 1 to 5 carbon atoms, an alkenyl group having 2 to 5 carbon atoms, or an alkynyl group having 2 to 5 carbon atoms, but at least one of L¹⁰¹ to L¹¹² represents an alkyl group having 1 to 5 carbon atoms, an alkenyl group having 2 to 5 carbon atoms, or an alkynyl group having 2 to 5 carbon atoms; L²⁰¹ to L²¹⁰ each independently represent a hydrogen atom, an alkyl group having 1 to 5 carbon atoms, an alkenyl group having 2 to 5 carbon atoms, or an alkynyl group having 2 to 5 carbon atoms, but at least one of L²⁰¹ to L²¹⁰ represents an alkyl group having 1 to 5 carbon atoms, an alkenyl group having 2 to 5 carbon atoms, or an alkynyl group having 2 to 5 carbon atoms; L³⁰¹ to L³⁰⁸ each independently represent a hydrogen atom, an alkyl group having 1 to 5 carbon atoms, an alkenyl group having 2 to 5 carbon atoms or an alkynyl group having 2 to 5 carbon atoms, but at least one of L³⁰¹ to L³⁰⁸ represents an alkyl group having 1 to 5 carbon atoms, an alkenyl group having 2 to 5 carbon atoms, or an alkynyl group having 2 to 5 carbon atoms; L⁴⁰¹ to L⁴⁰⁸ each independently represent a hydrogen atom, an alkyl group having 1 to 5 carbon atoms, an alkenyl group having 2 to 5 carbon atoms, or an alkynyl group having 2 to 5 carbon atoms, but at least one of L⁴⁰¹ to L⁴⁰⁸ represents an alkyl group having 1 to 5 carbon atoms, an alkenyl group having 2 to 5 carbon atoms, or an alkynyl group having 2 to 5 carbon atoms; and n represents an integer of 9 or less.

19. The releasing and dissolving composition according to claim 15, wherein the solvent of the ester compound as the component [II] is a solvent represented by formula (L-4) below: 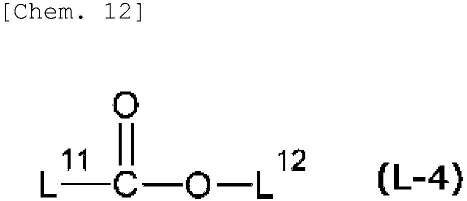 in the formula, L¹¹ and L¹² each independently represent an alkyl group having 1 to 6 carbon atoms, and a total of a number of carbon atoms in the alkyl group as L¹¹ and a number of carbon atoms in the alkyl group as L¹² is 7 or less.

20. The releasing and dissolving composition according to claim 15, wherein the releasing and dissolving composition further contains a component [III]: a solvent of glycol ethers.

21. The releasing and dissolving composition according to claim 20, wherein the solvent of the glycol ethers as the component [III] is a solvent represented by formula (T) below: 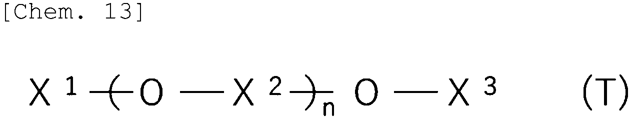 in the formula, X¹ and X³ each independently represent an alkyl group or an acyl group (X⁴-C(=O)-), X² represents an alkylene group, n represents 2 or 3. X⁴ represents an alkyl group.

22. The releasing and dissolving composition according to claim 15, wherein the quaternary ammonium salt as the component [I] is a halogen-containing quaternary ammonium salt.

23. The releasing and dissolving composition according to claim 15, wherein the amide-based solvent as the component [I] is an acid amide derivative represented by formula (Z) below or a compound represented by formula (Y) below: 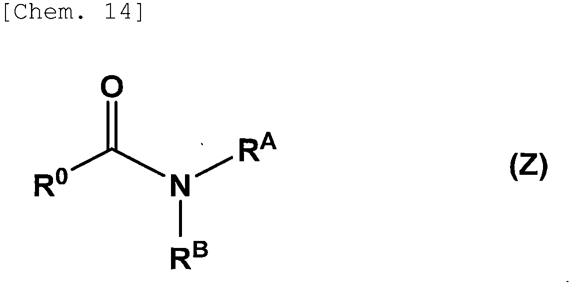
in the formula, R⁰ represents an ethyl group, a propyl group, or an isopropyl group, and R^{A} and R^{B} each independently represent an alkyl group having 1 to 4 carbon atoms, 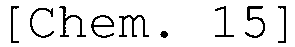 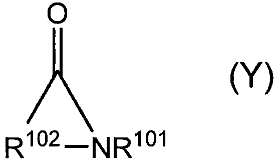
in the formula, R¹⁰¹ represents a hydrogen atom or an alkyl group having 1 to 6 carbon atoms, and R¹⁰² represents an alkylene group having 1 to 6 carbon atoms or a group represented by formula (Y1) below, and 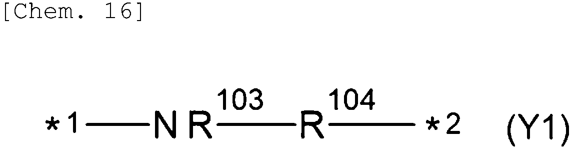
in the formula, R¹⁰³ represents a hydrogen atom or an alkyl group having 1 to 6 carbon atoms, R¹⁰⁴ represents an alkylene group having 1 to 5 carbon atoms, *1 represents a bonding hand bonded to a carbon atom in formula (Y), and *2 represents a bonding hand bonded to a nitrogen atom in formula (Y).

24. The releasing and dissolving composition according to claim 15, wherein the adhesive layer is a film obtained using an adhesive composition containing an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenol resin-based adhesive.

25. The releasing and dissolving composition according to claim 24, wherein the adhesive component (S) contains a siloxane-based adhesive.

26. The releasing and dissolving composition according to claim 25, wherein the siloxane-based adhesive contains a polyorganosiloxane component (A') that is cured by a hydrosilylation reaction.
